(19) Europäisches Patentamt / European Patent Office / Office européen des brevets

(11) **EP 4 712 078 A1**

(12) **DEMANDE DE BREVET EUROPEEN**

(43) Date de publication:
**18.03.2026 Bulletin 2026/12**

(21) Numéro de dépôt: **25199744.1**

(22) Date de dépôt: **02.09.2025**

(51) Classification Internationale des Brevets (IPC):
*G11C 11/16* (2006.01)      *G11C 11/18* (2006.01)

(52) Classification Coopérative des Brevets (CPC):
**G11C 11/18; G11C 11/1659; G11C 11/1675;**
G11C 11/1673

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **17.09.2024 FR 2409883**

(71) Demandeur: **Commissariat à l'Energie Atomique et aux Energies Alternatives**
**75015 Paris (FR)**

(72) Inventeurs:
• **LY, Denys**
**38054 Grenoble Cedex 09 (FR)**
• **BILLOINT, Olivier**
**38054 Grenoble Cedex 09 (FR)**

(74) Mandataire: **Atout PI Laplace**
**Immeuble Up On**
**25 Boulevard Romain Rolland**
**CS 40072**
**75685 Paris Cedex 14 (FR)**

(54) **CIRCUIT ELECTRONIQUE DE MEMOIRE VIVE MAGNETIQUE A PILOTAGE EN COURANT**

(57)    Circuit électronique de mémoire vive comprenant une matrice (100) de cellules mémoires (10) incluant chacune au moins un pilier magnétique et une ligne à effet Hall de spin interagissant par couplage spin-orbite et formant un tripôle, chaque cellule (10) comprenant de plus un moyen de sélection de la connexion aux bornes dudit tripôle,
a. un terminal (WL(k)) de chaque cellule étant relié dans le circuit pour la sélection de cellules mémoires de la matrice selon une première dimension de la matrice à l'aide des moyens de sélection des cellules mémoires,
b. et une paire de terminaux (BL(i), BLB(i)) de chaque cellule étant reliée dans le circuit pour permettre une application commune, à des cellules mémoires de la matrice sélectionnées selon une deuxième dimension de la matrice, d'une énergie électrique pour la lecture ou l'écriture d'une information magnétique dans le pilier.

Ladite énergie électrique étant appliquée en faisant circuler un courant contrôlé par un circuit de pilotage en courant (111).

Fig. 7C

## Description

## Contexte technique

L'invention s'inscrit dans le domaine des mémoires informatiques vives (RAM pour *random access memory*) de type mémoires magnétiques ou MRAM c'est-à-dire utilisant l'orientation magnétique de l'électron pour enregistrer l'information sur le long terme. Il s'agit de mémoires vives dites non volatiles. Les cellules sont constituées de deux couches ferromagnétiques, par exemple de l'alliage borure de cobalt-fer CoFeB, séparées par une couche isolante comme l'oxyde de magnésium MgO, chaque cellule étant organisée sous la forme d'un pilier des trois couches. Le pilier est appelé nanopilier du fait des dimensions nanométriques des structures utilisées. La première couche ferromagnétique est un aimant dont la polarité est fixée ; la seconde a une polarité qui peut être modifiée, permettant ainsi le stockage de données. Cette configuration utilise le phénomène de magnétorésistance à effet tunnel pour stocker un bit et le conserver à l'abri d'influences extérieures. L'information peut être lue par mesure de la résistance électrique de la cellule.

Les premières MRAM développées ont été de type STT-MRAM, STT signifiant *spin transfer torque,* ou couple de transfert de spin en français, en référence à un phénomène se produisant lorsqu'un courant polarisé en spin traverse un matériau magnétique et agit sur l'aimantation. Dans la STT-MRAM, le courant, aux fins de l'écriture, traverse la jonction à effet magnétotunnel MTJ d'une couche ferromagnétique à l'autre, ce qui est résumé couramment par l'affirmation selon laquelle lecture et écriture se font selon le même chemin.

Plus récemment, des MRAM de type SOT-MRAM ont été développées, SOT signifiant *spin orbit torque* ou *spin orbit transfer* et en français couple ou transfert spin-orbite. L'écriture est effectuée en injectant un courant dans une piste ou ligne placée dans un plan perpendiculaire aux piliers, et qui peut être constituée d'un métal lourd comme le tungstène W. Elle est fondée sur l'effet Hall de spin. Étant donné que le courant d'écriture dans la SOT-MRAM passe parallèlement aux couches, le courant d'écriture ne génère pas d'usure du pilier MTJ. On peut donc augmenter l'amplitude du courant d'écriture pour améliorer la vitesse d'écriture. La technologie SOT permet ainsi d'envisager des temps d'écriture plus faibles que pour les cellules STT, sans compromettre la durée de vie des dispositifs. La lecture par contre se fait toujours par mesure de la résistance électrique de la cellule, et on dit donc qu'il y a découplage des chemins de lecture et écriture, au contraire du fonctionnement des STT-MRAM. Pour une revue sur les mémoires de technologie SOT-MRAM, on peut se référer à Krizakova et al., « Spin-orbit torque switching of magnetic tunnel junctions for memory applications », Journal of Magnetism and Magnetic Materials, 562:169692, 2022 ou à S. Lee et al., « Emerging Three-Terminal Magnetic Memory Devices », in Proceedings of the IEEE, 104(10):1831-1843, 2016. Pour une revue abordant la lecture, qui peut se faire de la même manière sur une STT-MRAM ou une SOT-MRAM on peut se référer à T. Na et al., « STT-MRAM Sensing: A Review », in IEEE Transactions on Circuits and Systems II: Express Briefs, 68(1):12-18, 2021.

L'invention décrite ci-après est présentée en particulier, sans y être limitée néanmoins, aux MRAM de type SOT-MRAM.

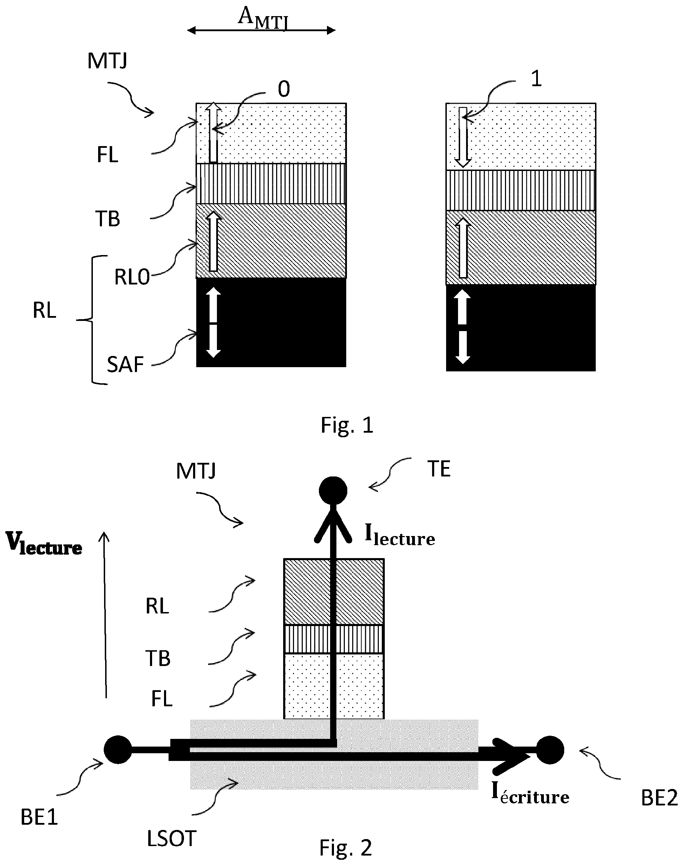

[Fig. 1] En référence à la figure 1, une cellule de mémoire SOT-MRAM, chargée de stocker un bit unique, comprend un pilier dit pilier magnétique MTJ comprenant une jonction à effet tunnel magnétique. Le pilier magnétique MTJ est constitué de l'empilement, selon la direction du pilier, de blocs délimités latéralement et formés dans des couches de matériaux selon la succession suivante, de bas en haut sur la figure 1

- une couche ferromagnétique à aimantation fixe RL constituée, de bas en haut sur la figure 1,

- d'une sous-couche antiferromagnétique synthétique SAF (la figure 1 présente des aimantations opposées en proportion équivalente dans cette couche : l'aimantation totale est nulle)

- et d'une couche ferromagnétique dite couche de référence RL0 d'aimantation fixe (la figure 1 montre une aimantation uniforme dans la couche et identique dans la vue de gauche et dans la vue de droite), ces deux sous-couches SAF et RL0 étant au contact l'une de l'autre, l'ensemble étant assimilé à la couche de référence elle-même, d'où la notation RL pour l'ensemble de SAF et RL0,

- une couche d'oxyde formant la barrière tunnel TB au contact de la couche de référence RL0, et d'épaisseur quelques nanomètres,

- une couche ferromagnétique à aimantation variable ou couche libre FL (la figure 1 montre une aimantation uniforme dans la couche et opposée dans la vue de gauche vis-à-vis de la vue de droite), au contact de la couche d'oxyde.

La couche d'oxyde constitue une fine barrière matérielle entre les deux couches ferromagnétiques.

La délimitation latérale (de forme circulaire ou polygonale, par exemple) des blocs de matériaux définit une aire $A_{MTJ}$, transversalement à la direction du pilier magnétique MTJ.

La couche à aimantation variable FL mémorise une donnée binaire (un bit) sous la forme d'un état 0 ou parallèle (P) offrant une résistance électrique basse $R_P$, sur la partie gauche de la figure 1, ou d'un état 1 anti-parallèle (AP) offrant une résistance électrique haute $R_{AP}$, sur la partie droite de la figure 1.

Les paramètres électriques de la jonction ou du pilier MTJ incluent le produit résistance-aire $RA_{MTJ}$ noté RA et l'écart relatif de résistance TMR.

Le produit résistance-aire RA, qui est de l'ordre de 5 à 5000 $\Omega.\mu m^2$ est contrôlable par l'épaisseur de la couche barrière TB, et il impacte directement la valeur de résistance basse associée à l'état P qui lui est proportionnelle selon la relation : $R_P = RA/A_{MTJ}$.

L'écart relatif de résistance TMR est lié à la différence de résistance entre l'état P et l'état AP par la relation $TMR = \frac{R_{AP}-R_P}{R_P}$ . Cet écart est en général entre 0,8 et 2 c'est à dire entre 80 et 200%.

Pour un écart relatif de résistance TMR de 100% et un pilier MTJ de géométrie circulaire et de diamètre de 40 nm si RA = 5 $\Omega.\mu m^2$ on a des résistances dans les deux états qui valent $R_P = 4$ k$\Omega$ et $R_{AP} = 8$ k$\Omega$. Si RA = 20 $\Omega.\mu m^2$ les valeurs de résistance sont $R_P = 16$ k$\Omega$ et $R_{AP} = 32$ k$\Omega$. Si RA = 1000 $\Omega.\mu m^2$ les valeurs de résistance sont $R_P = 800$ k$\Omega$ et $R_{AP} = 1,6$ M$\Omega$. Un TMR faible rend difficile les opérations de lecture.

[Fig. 2] En figure 2, le pilier MTJ est représenté en ne distinguant pas RL0 et SAF au sein de RL, et en plaçant RL en haut de la figure 2, et FL en bas de la figure 2.

Le pilier MTJ est placé sur une piste LSOT (aussi appelée ligne, ou ligne SOT) d'un métal lourd tel que le tungstène W, le platine Pt, ou le tantale Ta, ou d'un isolant topologique, ou des mélanges ou alliages de ces matériaux. La piste LSOT est au contact de la couche libre FL, qui est donc placée entre la barrière tunnel TB et la piste LSOT.

Néanmoins il est aussi connu des solutions dans lesquelles la piste SOT est placée au-dessus du pilier MTJ, et les couches RL et FL sont alors inversées pour garder la couche FL en contact avec la piste SOT.

Le retournement de l'aimantation de la couche libre FL se produit par conversion d'un courant électrique d'écriture $I_{\text{écriture}}$, qui est un déplacement de charges électriques entre deux bornes BE1 et BE2 de la LSOT, en un courant de spin. La circulation du courant $I_{\text{écriture}}$ au travers de la ligne SOT produit en effet un courant de spin (non représenté) perpendiculaire à $I_{\text{écriture}}$, se propageant dans la ligne LSOT vers l'interface entre la ligne SOT LSOT et la couche libre FL, ce qui entraîne le retournement de l'aimantation de la couche libre FL. Il s'agit d'une interaction entre le pilier magnétique et la ligne SOT par couplage spin-orbite. La ligne SOT est appelée ligne à effet Hall de Spin.

Comme mentionné, les mémoires SOT-MRAM ont l'avantage de découpler le chemin d'écriture de celui de lecture : lors d'une opération d'écriture, le courant d'écriture, $I_{\text{écriture}}$, déjà mentionné, ne circule qu'au travers de la ligne SOT, sans passer au travers du pilier MTJ. La vitesse d'écriture peut donc être augmentée sans impacter négativement l'endurance dans le temps de la mémoire.

Par contre, lors d'une opération de lecture, le courant de lecture $I_{\text{lecture}}$, circule au travers du pilier MTJ, entre la borne BE1 (et/ou BE2) de la ligne LSOT et une borne TE de la couche de référence RL.

On relève que le pilier magnétique MTJ et la piste LSOT forment un tripôle (BE1, BE2, TE)

On relève aussi que la valeur du produit résistance-aire RA n'a pas d'impact sur les opérations d'écriture.

Lors d'une opération d'écriture dans une cellule SOT le sens de circulation du courant d'écriture, $I_{\text{écriture}}$, dépend de la donnée à écrire (il a été représenté sur la figure 2 dans le sens de BE1 à BE2, mais il peut aussi être orienté de BE2 vers BE1, mais alors la donnée écrite est la donnée opposée). L'amplitude du courant d'écriture, $I_{\text{écriture}}$, dépend par ailleurs de plusieurs paramètres : la surface du pilier MTJ $A_{MTJ}$, la nature du matériau de la ligne LSOT et ses dimensions, le matériau et les dimensions de la couche libre FL et la vitesse d'écriture souhaitée, notamment.

Pour une ligne LSOT en tungstène W, une couche libre en CoFeB, un pilier MTJ circulaire de diamètre 40 nm, le courant d'écriture $I_{\text{écriture}}$ est estimé à 260 $\mu$A pour une écriture en 1 ns, ou 200 $\mu$A pour une écriture en 10 ns. Les courants d'écriture d'une mémoire SOT-MRAM sont de l'ordre de quelques centaines de $\mu$A.

Les lignes SOT sont en général fines, de l'ordre de quelques nm, ce qui leur confère une forte résistivité. Pour une ligne SOT en tungstène W (de résistivité $\rho_W = 160$ $\mu\Omega$.cm), d'une épaisseur de 5 nm, d'une largeur de 40 nm : la résistance est $R_{SOT,W}$ de l'ordre de 300 $\Omega$ pour une longueur d'environ 50 nm et $R_{SOT,W}$ est de l'ordre de 1 k$\Omega$ pour une longueur d'environ 120 nm.

Typiquement, comme convention, pour une écriture de la valeur '0', on considère que le courant d'écriture, $I_{\text{écriture}}$, circule de BE1 vers BE2 et que le pilier MTJ, au niveau de sa couche libre, passe de l'état anti-parallèle AP à parallèle P, et pour une écriture de la valeur '1', le courant d'écriture, $I_{\text{écriture}}$, circule de BE2 vers BE1, et le pilier passe de l'état parallèle P à anti-parallèle AP.

La lecture de l'information binaire stockée dans le pilier MTJ peut être effectuée à tension constante. On applique une tension constante de lecture, $V_{\text{lecture}}$, entre les bornes BE1 et TE du pilier MTJ. $V_{\text{lecture}}$ est limitée par la tension de claquage du pilier MTJ, de l'ordre de 1 à 2 V, en fonction notamment de la valeur de RA. L'application de cette tension fait circuler un courant de lecture, $I_{\text{lecture}}$, à travers le pilier MTJ. La valeur de $I_{\text{lecture}}$ dépend de l'état de magnétisation, P ou AP, du pilier MTJ. La valeur du courant de lecture dans l'état P, $I_{\text{lecture},0}$, doit être supérieure à celle dans l'état AP, $I_{\text{lecture},1}$. $I_{\text{lecture},0}$ et $I_{\text{lecture},1}$ sont typiquement d'au moins 10 $\mu$A avec une différence $\Delta I_{\text{lecture}}$ d'au moins 5 $\mu$A.

La lecture de l'information binaire stockée dans le pilier MTJ peut aussi être effectuée à courant constant. On fait circuler un courant de lecture constant à travers le pilier MTJ, $I_{lecture}$. $I_{lecture}$ ne doit pas perturber l'état de magnétisation du pilier MTJ par écriture parasite STT ($I_{lecture} < 60\ \mu A$). La circulation du courant génère une chute de tension, $V_{lecture}$, entre les bornes BE1 et TE du pilier MTJ. La valeur de $V_{lecture}$ dépend de l'état de magnétisation, P ou AP, du pilier MTJ. La valeur de $V_{lecture}$ dans l'état P, $V_{lecture,0}$, doit être inférieure à celle dans l'état AP, $V_{lecture,1}$. Typiquement, la différence de tension $\Delta V_{lecture}$, entre $V_{lecture,0}$ et $V_{lecture,1}$ est d'au moins 100 mV.

On retient que $I_{écriture}$ ne circule que dans la ligne SOT, et que l'opération d'écriture est indépendante de la valeur RA du pilier MTJ.

On retient aussi qu'il est nécessaire de contrôler précisément la valeur de $I_{écriture}$ pour les opérations d'écriture, et que $I_{écriture}$ a des valeurs élevées avec les matériaux actuels.

Pour une implémentation matricielle, des composants de sélection, typiquement des transistors de type NMOS sont utilisés. Cela a par exemple été abordé dans M. Gupta et al., « High-density SOT-MRAM technology and design specifications for the embedded domain at 5nm node », IEEE IEDM, pp.24.5.1-24.5.4, 2020. Comme la mémoire SOT-MRAM a trois terminaux (BE1, BE2, et TE), elle nécessite deux composants de sélection (e.g.: 2 transistors NMOS) par cellule mémoire (bitcell) SOT-MRAM. Cette configuration est connue sous la désignation 2T1R pour 2 transistors et une résistance. La résistance est le pilier magnétique et une partie de la ligne SOT. La cellule est nommée cellule mémoire SOT-MRAM 2T1R.

Il y a deux implémentations possibles :

(i) 1 transistor NMOS connecté à BE1 (ou BE2) et 1 transistor NMOS connecté à TE,

(ii) ou 1 transistor NMOS connecté à BE1 et 1 transistor NMOS connecté à BE2.

Généralement, les mémoires SOT-MRAM sont pilotées avec des sources de tension constantes, comme dans US2018/0061467A1. Les sources de tension peuvent être placées en dehors de la matrice mémoire. Une tension constante générée par les sources de tension, $V_{écriture}$, est appliquée entre deux lignes d'accès (le signe de $V_{écriture}$ dépend de la donnée à écrire, '0' ou '1'), ce qui génère un courant $I_{écriture}$ circulant dans la ligne SOT LSOT. A cause des résistances parasites de routage des lignes d'accès, ainsi que des courants de fuite dans les cellules mémoires non sélectionnées, la tension réellement appliquée aux bornes d'une cellule mémoire sélectionnée diminue à mesure que l'on s'éloigne des circuits de pilotage. Ceci résulte en une diminution du courant d'écriture $I_{écriture}$ à mesure que l'on s'éloigne des circuits de pilotage : la cellule mémoire la plus éloignée des circuits de pilotage a en conséquence le courant $I_{écriture}$ le plus faible ; la cellule mémoire la plus proche des circuits de pilotage a le courant $I_{écriture}$ le plus élevé. L'amplitude du courant d'écriture peut être différente selon que l'on écrit un '0' ou un '1' à cause de l'asymétrie des structures : le courant d'écriture '1', $I_{écriture,1}$, est généralement plus élevé que le courant d'écriture '0', $I_{écriture,0}$, et il est difficile de contrôler indépendamment l'une de l'autre les valeurs de ces deux courants.

Par défaut, pour une même tension $V_{écriture}$ appliquée en écriture '0' ou '1' (la polarité de $V_{écriture}$ dépendant de la donnée à écrire), les courants $I_{écriture,0}$ et $I_{écriture,1}$ ont généralement des valeurs différentes à cause de l'asymétrie des structures. Ceci est un problème si on veut des amplitudes de $I_{écriture,0}$ et $I_{écriture,1}$ égales. Toutefois, dans certains cas, on peut également vouloir que $I_{écriture,0}$ et $I_{écriture,1}$ aient des amplitudes différentes. On pourrait alors utiliser deux valeurs de tension différentes pour l'écriture '0' ($V_{écriture,0}$) et '1' ($V_{écriture,1}$). Cependant, dans les deux cas (amplitudes égales ou amplitudes différentes), il est difficile de contrôler précisément, et indépendamment, la valeur des deux courants lorsqu'on pilote en tension, ie. il est difficile de trouver des valeurs appropriées de $V_{écriture,0}$ en écriture '0' et $V_{écriture,1}$ en écriture '1' pour obtenir les courants d'écriture souhaités. La solution décrite ci-après permet de résoudre ce problème et permet de facilement contrôler les valeurs de $I_{écriture,0}$ et $I_{écriture,1}$.

Lors d'une opération d'écriture, un courant de fuite, $I_{MTJ}$, peut circuler à travers le pilier MTJ de la cellule mémoire sélectionnée car il est difficile de contrôler la tension aux bornes du pilier MTJ. De plus, $I_{MTJ}$ augmente pour des valeurs RA du pilier MTJ faibles et dépend de l'état de magnétisation du pilier MTJ.

Les problèmes mentionnés ci-dessus rendent complexes le dimensionnement et l'utilisation du circuit mémoire. Par exemple il est nécessaire d'avoir une connaissance précise des valeurs de résistances parasites de routage, des courants de fuite et des variations de procédé de fabrication, et il faut dimensionner les transistors d'accès pour contrôler la valeur de $I_{écriture}$ qui circule dans une cellule mémoire sélectionnée. L'invention et ses avantages

Pour résoudre les difficultés ainsi identifiées, il est proposé un circuit électronique de mémoire vive comprenant une matrice de cellules mémoires incluant chacune au moins un pilier magnétique et une ligne à effet Hall de spin interagissant par couplage spin-orbite et formant un tripôle, chaque cellule comprenant de plus un moyen de sélection de la connexion aux bornes dudit tripôle,

-   un terminal de chaque cellule étant relié dans le circuit pour la sélection de cellules mémoires de la matrice selon une première dimension de la matrice - typiquement des lignes de mots - à l'aide des moyens de sélection des cellules mémoires,

- et une paire de terminaux de chaque cellule étant reliée dans le circuit pour permettre une application commune, à des cellules mémoires de la matrice sélectionnées selon une deuxième dimension de la matrice - typiquement des lignes de bits - d'une énergie électrique pour la lecture ou l'écriture d'une information magnétique dans le pilier,

De manière remarquable, ladite énergie électrique est appliquée en faisant circuler un courant contrôlé par un circuit de pilotage en courant.

Au lieu de piloter la matrice mémoire en tension, on pilote la matrice mémoire entièrement en courant.

L'invention utilise un pilotage en courant qui comprend au moins un générateur de courant qui peut faire circuler un courant constant dans les lignes de bits. L'invention utilise également un circuit de polarisation qui comprend une alimentation en tension qui polarise les lignes de bits à des tensions appropriées pour le pilotage en courant.

Pendant une opération d'écriture, le circuit de pilotage génère un courant d'écriture de référence, $I_{ref,écriture}$, qui circule à travers la ligne SOT de la cellule mémoire sélectionnée. Pendant une opération de lecture, le circuit de pilotage génère un courant de lecture de référence constant, $I_{ref,lecture}$, qui circule à travers le pilier MTJ de la cellule mémoire sélectionnée.

Le courant d'écriture circulant à travers la cellule mémoire sélectionnée, $I_{écriture}$, est ainsi constant, quelle que soit la position de celle-ci dans la matrice mémoire ($I_{écriture} \approx I_{ref,écriture}$). La valeur du courant d'écriture, $I_{écriture}$, est, de plus, plus robuste face aux résistances parasites de routage des lignes d'accès et des courants de fuite à travers les cellules mémoires non sélectionnées. La valeur de $I_{écriture}$ dépend majoritairement du courant d'écriture de référence, $I_{ref,écriture}$, et du dimensionnement des transistors NMOS d'accès des cellules mémoires. Le dimensionnement et l'utilisation du circuit mémoire sont plus simples lorsqu'un pilotage en courant est mis en place : sans avoir une connaissance précise des résistances parasites de routage, des courants de fuite, des variations induites par le procédé de fabrication, on contrôle néanmoins la valeur de $I_{écriture}$ en contrôlant seulement la valeur de $I_{ref,écriture}$ (sachant que $I_{écriture} \sim I_{ref,écriture}$). On dimensionne préalablement les transistors NMOS d'accès suffisamment grands pour laisser circuler $I_{écriture}$ dans la cellule mémoire.

Les valeurs des courants d'écriture '0' et '1' peuvent être obtenues identiques, même si la structure est asymétrique. Toutefois, si nécessaire, on peut également avoir des valeurs de courant différentes, en choisissant des valeurs de $I_{ref,écriture}$ différentes en écriture '0' et écriture '1'.

Le courant de fuite à travers le pilier MTJ, $I_{MTJ}$, est quasi-nul. Cette solution est compatible avec de faibles tensions d'alimentation (<1V).

De manière optionnelle et avantageuse,

l'énergie électrique peut être appliquée par des branches de recopie de miroirs de courant chacune associée à une ligne de cellules selon la deuxième dimension, un transistor desdits miroirs de courant étant mutualisé pour former une branche de référence commune desdits miroirs de courant.

- l'énergie électrique peut être appliquée par une branche de recopie commune à plusieurs lignes de cellules selon la deuxième dimension de la matrice, un contrôleur du circuit sélectionnant une ligne de cellules pour la connecter sélectivement à ladite branche de recopie commune.

- l'énergie électrique pour l'écriture peut être appliquée en connectant à une même borne de la ligne à effet Hall de spin une première source de courant avec miroir de courant associé PMOS pour l'écriture de la première valeur binaire, et une deuxième source de courant avec miroir de courant associé NMOS pour l'écriture de la deuxième valeur binaire.

- l'énergie électrique pour l'écriture peut être appliquée en connectant une source de courant à une première borne de la ligne à effet Hall de spin pour l'écriture de la première valeur binaire et à une deuxième borne de la ligne à effet Hall de spin pour l'écriture de la deuxième valeur binaire, un contrôleur du circuit polarisant la borne de la ligne à effet Hall opposée à la source de courant en fonction de la valeur binaire à écrire.

- l'énergie électrique pour la lecture peut être appliquée en connectant une source de courant selon les principes décrits dans la description faite ci-après en lien avec les figures. En particulier, l'énergie électrique pour la lecture peut être appliquée en connectant une source de courant à une extrémité d'un pilier magnétique opposée à la ligne à effet Hall de spin, la ligne à effet Hall de spin étant polarisée pour l'opération de lecture.

- l'énergie électrique pour la lecture peut être appliquée dans le pilier magnétique dans un premier sens ou un sens opposé en fonction d'une valeur écrite au cours d'une opération d'écriture simultanée.

- le circuit de pilotage en courant peut faire de plus circuler un courant d'assistance à travers le pilier magnétique pour faciliter ou s'opposer à l'écriture, par exemple par des effets STT ou VCMA (voltage-controlled magnetic anisotropy ou anisotropie magnétique contrôlée par tension).

- le circuit électronique de mémoire vive magnétique peut comprendre un circuit de polarisation placé par rapport à la matrice en opposition vis-à-vis du circuit de pilotage en courant.

- le moyen de sélection peut comprendre deux transistors à effet de champ reliés chacun par une source ou un drain à une borne respective de l'ensemble formé par le pilier magnétique et la ligne à effet Hall de spin.

- les cellules peuvent être des cellules SWL1 ou SWL2.

- les cellules mémoires peuvent être des cellules à pilier magnétique unique, ou à deux ou trois piliers magnétiques.

Les structures multi-piliers utilisées pour l'invention peuvent avoir de nombreux piliers magnétiques disposés sur une ligne SOT et comprendre un élément de sélection en plus à chaque fois qu'on ajoute un pilier, typiquement un transistor NMOS sur le haut de chaque pilier magnétique ajouté.

Des structures multi-piliers auxquelles s'applique l'invention peuvent comprendre quelques piliers magnétiques seulement, et notamment 4 piliers, pour avoir un équivalent 2 bits ou un autre nombre de piliers magnétique inférieur à 20, ou éventuellement supérieur.

L'invention, décrite avec la cellule SWL1 est transposable à la structure SWL2 et également à la structure SOT-5T, dont tous les terminaux sont indépendants. Les principaux modes de réalisation sont compatibles avec la structure SOT-SBL.

**Liste des figures**

La figure 1, déjà commentée, représente la structure d'un pilier magnétique utilisé dans l'invention, dans les deux états d'aimantation.

La figure 2, déjà commentée, présente le principe des mémoires SOT.

La figure 3 présente une cellule de MRAM SOT-5T.

La figure 4 présente une cellule appelée SOT-SWL1 (4T).

La figure 5 présente un circuit mémoire selon un mode de réalisation de l'invention.

La figure 6 présente la matrice mémoire selon le mode de réalisation.

La figure 7A présente le circuit de pilotage selon le mode de réalisation.

Les figures 7B et 7C présentent des exemples d'implémentation du circuit de la figure 7A.

La figure 8A présente un détail de l'implémentation, dans un mode de réalisation.

La figure 8B explicite le fonctionnement.

Les figures 9 et 10 présentent d'autres cellules de MRAM SOT auxquelles l'invention s'applique.

La figure 11, à comparer à la figure 8A, présente un autre mode de réalisation de l'invention, avec adressage d'une seule ligne mémoire à la fois.

La figure 12 présente un autre mode de réalisation, avec déportage d'une des deux sources de courant, utilisant des miroirs de courant PMOS pour injection de courant.

La figure 13 présente un autre mode de réalisation, avec déportage d'une des deux sources de courant, utilisant des miroirs de courant NMOS pour absorption de courant.

La figure 14 présente un autre mode de réalisation, avec lecture et écriture simultanées.

Les figures 15 à 18 présentent les principes de l'assistance à l'écriture par courant STT.

Les figures 19 à 24 présentent un mode de réalisation avec assistance à l'écriture par courant STT.

Les figures 25 et 26 présentent les principes de l'assistance à l'écriture par tension VCMA.

Les figures 27 à 32 présentent un mode de réalisation avec assistance à l'écriture par tension VCMA.

**Description d'exemples en lien avec les figures**

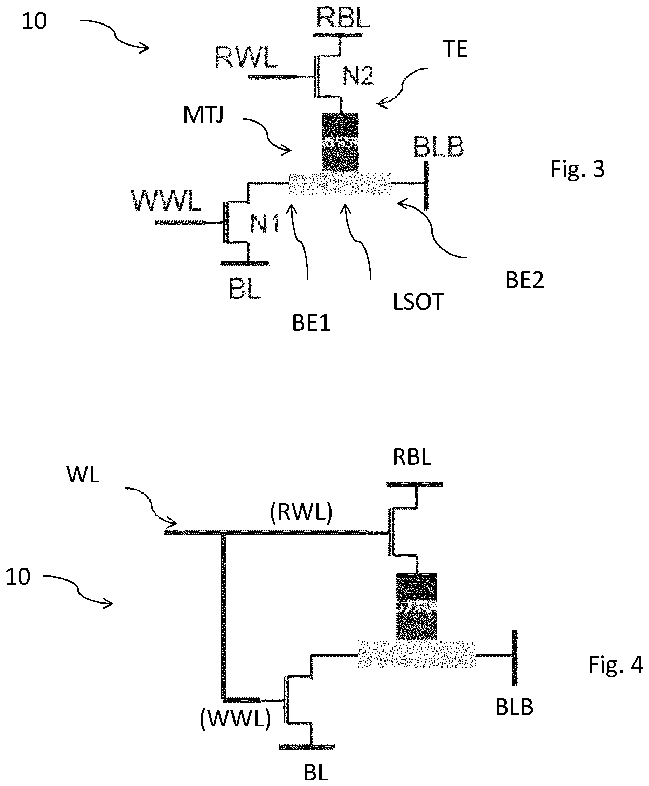

[Fig. 3]. En référence à la figure 3, on aborde la configuration dans laquelle la cellule comprend un transistor NMOS connecté à BE1, ici ce transistor est noté N1, et un transistor NMOS connecté à TE, ici ce transistor est noté N2. La cellule mémoire 10 peut avoir jusqu'à cinq terminaux indépendants - et ces terminaux sont notés

- RWL, WWL (terminaux des grilles des deux transistors NMOS, WL signifiant par ailleurs wordline ou ligne de mots et R et W read et write, ou lecture et écriture), on applique à ces terminaux soit le potentiel de la masse (0V) soit le potentiel de l'alimentation $V_{DD}$, et ces terminaux sont reliés,

- pour le premier RWL à un conducteur commun à toutes les cellules d'une colonne donnée d'indice k dans la matrice, noté RWL(k) dédié à la sélection aux fins de la lecture des cellules de la colonne k,

- et pour le deuxième WWL à un conducteur commun à toutes les cellules de la colonne d'indice k dans la matrice, noté WWL(k) et dédié à la sélection aux fins de l'écriture des cellules de la colonne k

- et BL, BLB, et RBL (les trois autres terminaux, BL et BLB étant sur la ligne LSOT, et RBL étant à la borne TE, deux de ces trois connexions se faisant par un des transistors NMOS, BL signifiant par ailleurs bitline ou ligne de bits, BLB signifiant bitline bar et surtout potentiel opposé, le terminal BLB étant destiné à l'écriture, et R dans RBL signifiant read ou lecture), ces terminaux sont reliés,

- pour le premier BL à un conducteur commun à toutes les cellules d'une ligne donnée d'indice i dans la matrice, noté BL(i) et dédié à l'écriture et à la lecture des cellules de la ligne i,

- et pour le deuxième BLB à un conducteur commun à toutes les cellules de la ligne d'indice i dans la matrice, noté BLB(i) et dédié à l'écriture et à la lecture des cellules de la ligne i,

- pour le troisième RBL à un conducteur commun à toutes les cellules de la ligne d'indice i dans la matrice, noté RBL(i) et dédié à la lecture, et éventuellement à l'écriture, des cellules de la ligne i.

[Fig. 4] Il est possible de mutualiser certains terminaux pour faciliter le routage des lignes d'accès et réduire la surface de la cellule mémoire, et cela est représenté en figure 4.

S'il y a mutualisation des terminaux WWL et RWL, et qu'il y a un des deux transistors NMOS à la borne TE, la cellule est appelée la cellule SOT-SWL1 (SOT shared wordline 1 - et faisant référence à la notion de ligne de mots partagée). C'est celle qui est représentée en figure 4. Il y a dans ce cas 4 terminaux, notés WL (qui inclut WWL et RWL), BL, BLB, et RBL.

S'il y a mutualisation des terminaux BL et RBL, la cellule s'appelle SOT-SBL (SOT shared bitline) et a 4 terminaux notés WWL, RWL, BL (qui inclut RBL), et BLB.

Si les deux transistors NMOS sont aux bornes BE1 et BE2, la cellule est appelée la cellule SOT-SWL2 (SWL signifiant à nouveau shared wordline,). Il y a 4 terminaux, notés WL (qui inclut à nouveau WWL et RWL), BL, BLB, et RBL.

Si les terminaux ne sont pas mutualisés (c'est ce qui est représenté en figure 3), la cellule est appelée SOT-5T (SOT 5 terminals).

On a simulé une ligne mémoire de 2048 cellules SWL1 (avec partage de BL, BLB, et RBL) en ligne, avec la tension d'alimentation du circuit $V_{DD}$=0,9 V, des longueurs de canal des deux transistors N1 et N2 $L_{N1}=L_{N2}$ = 20 nm, des largeurs de canal des deux transistors N1 et N2 $W_{N1}$ = 1 $\mu$m, $W_{N2}$ = 80 nm, un produit résistance-aire RA = 20 $\Omega.\mu m^2$, une résistance de la ligne LSOT $R_{SOT} \approx 300 \Omega$. Le pilotage est en tension. La topologie est BL, BLB, RBL perpendiculaires à WL. Les résultats obtenus sur une ligne mémoire de 2048 cellules sont transposables à une matrice de 4 Mbit, avec 2048 lignes et 2048 colonnes.

Le courant d'écriture de la cellule mémoire la plus éloignée (n° 2048) est environ 2 fois plus faible que celui de la cellule mémoire la plus proche (n° 1) à cause des résistances parasites des lignes d'accès BL et BLB pour une valeur de résistance parasite $R_{BL,par} = R_{BLB,par} = 0.3\ \Omega$/cellule et des courants de fuite pris en compte dans la simulation. Le courant d'écriture '0' est environ 1,5 fois plus faible que celui en écriture '1'.

Par ailleurs, pour un produit résistance aire du pilier RA=20 $\Omega.\mu m^2$ et un l'écart relatif de résistance TMR=100% ($R_P$=16 k$\Omega$ et $R_{AP}$=32 k$\Omega$), les courants de fuite dans le pilier MTJ, $I_{MTJ}$, peuvent aller jusqu'à environ 7 $\mu$A, et jusqu'à 17 $\mu$A pour RA=5 $\Omega.\mu m^2$. Plus la valeur des résistances parasites augmente, plus les courants de fuite dans le pilier MTJ augmentent.

Ainsi, du fait du pilotage en tension, à cause de la non-uniformité du courant d'écriture entre la cellule mémoire la plus proche et la plus éloignée, et entre l'écriture '0' et '1', il est souvent choisi de dimensionner le circuit mémoire en fonction du scenario « pire cas », ie. s'assurer que le courant d'écriture '0' de la cellule mémoire la plus éloignée soit suffisamment élevé. Or cela implique un surdimensionnement pour les autres cellules mémoires, ie. le courant d'écriture des autres cellules mémoires est trop élevé, jusqu'à 4 fois plus élevé. Ceci implique une consommation énergétique superflue et des risques de dégradation des lignes SOT qui sont généralement très fines, de l'ordre de 3 à 5 nm. Par ailleurs, le dimensionnement du circuit mémoire est complexe car l'amplitude du courant d'écriture dépend de plusieurs paramètres, tels que les valeurs des résistances parasites de routage, la taille de la matrice mémoire, le choix et le dimensionnement des éléments de sélection des cellules mémoires, les variations liées au procédé de fabrication. Le dimensionnement est d'autant plus compliqué que les courants d'écriture impliqués sont supérieurs à 200 $\mu$A. Enfin, il est difficile de limiter les courants de fuite à travers le pilier MTJ lors d'une opération d'écriture : ceci dégrade l'endurance de la matrice mémoire.

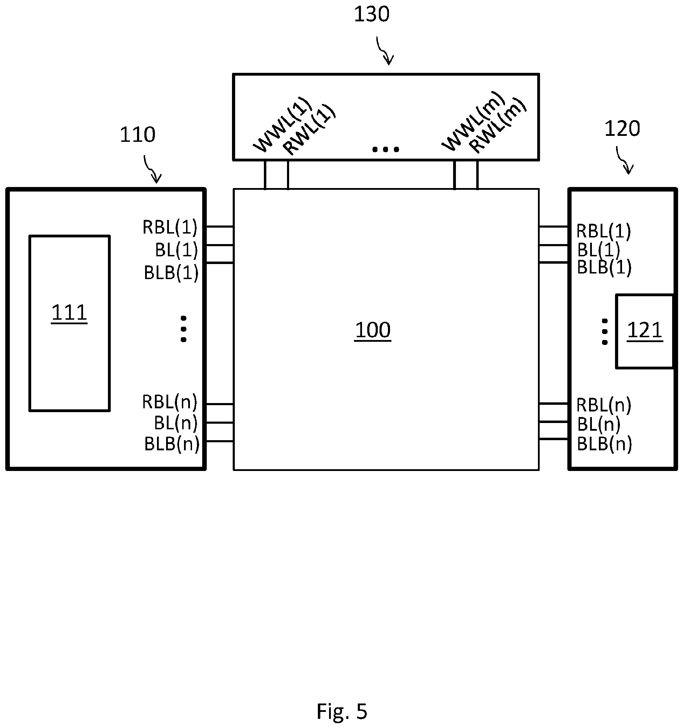

[Fig. 5] Pour une matrice mémoire 100 de type SOT-MRAM de m mots de chacun n bits, telle que celle représentée en figure 5, le circuit de pilotage en courant est composé

- d'un dispositif d'adressage 110 qui comprend une source de courant 111 générant les courants $I_{ref,écriture}$ et $I_{ref,lecture}$, et qui connecte la source de courant 111 aux lignes mémoires sélectionnées (ie. les lignes de bits RBL, BL, et BLB sélectionnées entre le bit 1 et le bit n),

- d'un circuit de polarisation 120 qui comprend une alimentation en tension 121 et polarise les lignes de bits de 1 à n à des tensions appropriées,

- et enfin d'un circuit d'adressage 130 des lignes de mot qui sélectionne une colonne mémoire entre le mot 1 et le mot m.

Le courant $I_{ref,écriture}$ peut circuler de BL vers BLB, ou de BLB vers BL selon que la donnée à écrire est '0' ou '1', respectivement.

Le courant $I_{ref,lecture}$ peut circuler de RBL vers BLB, ou de RLB vers BL, ou encore de BLB vers RBL ou encore de BL vers RBL.

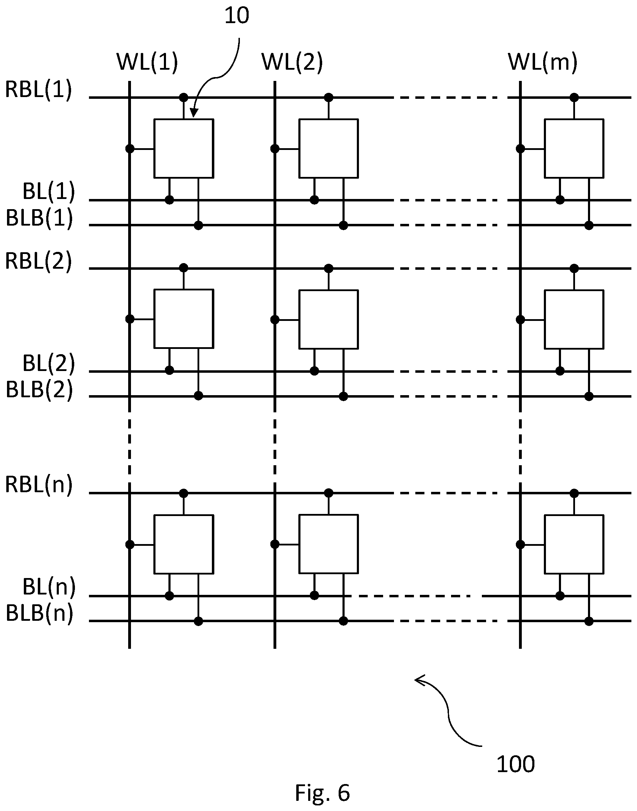

[Fig. 6] En figure 6, on a présenté une matrice mémoire 100 de cellules 10. Le mode de réalisation présenté utilise la cellule mémoire 2T1R SWL1 qui a donc, comme exposé précédemment, 4 terminaux indépendants (RWL et WWL sont mutualisées et notées WL). L'invention est applicable, dans ses principaux modes de réalisation, aux autres structures de cellules mémoires (e.g.: SOT-5T, SOT-SBL, et SOT-SWL2). La matrice mémoire fait l'objet de l'adressage par les terminaux RBL, BL, et BLB selon une même direction, et par le terminal WL selon la direction perpendiculaire à la précédente.

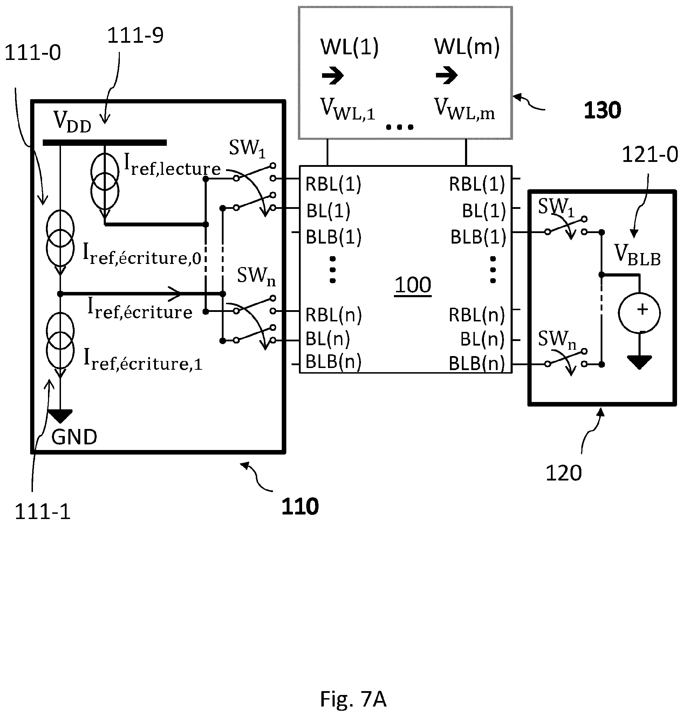

[Fig. 7A] En figure 7A, l'implémentation du circuit de pilotage répond aux principes suivants, pour la matrice mémoire 100 de type SOT-MRAM de m mots de chacun n bits.

L'écriture de la donnée '0' se fait par l'injection du courant $I_{ref,écriture,0}$, généré par une source de courant 111-0 dans la ligne BL sélectionnée (d'indice i du bit 1 au bit n), et ce courant circule de la ligne BL sélectionnée vers la ligne BLB sélectionnée (de même indice i) à travers la cellule mémoire sélectionnée.

L'écriture de la donnée '1' se fait par extraction du courant $I_{ref,écriture,1}$ généré par une source de courant 111-1, de la ligne BL sélectionnée (d'indice i du bit 1 au bit n), le courant circulant de la ligne BLB sélectionnée vers la ligne BL sélectionnée (de même indice i) à travers la cellule mémoire sélectionnée.

La figure montre que les sources de courant 111-0 et 111-1 ont une borne commune, et leurs secondes bornes sont respectivement reliées à la tension d'alimentation $V_{DD}$ et à la masse GND. Il s'agit néanmoins d'une vue simplifiée dans la mesure où le montage se fait potentiellement différemment.

La lecture à courant constant se fait par injection d'un courant $I_{ref,lecture}$ généré par une source de courant 111-9 dans la ligne RBL sélectionnée (d'indice i du bit 1 au bit n), le courant circulant à travers le pilier MTJ de la cellule mémoire sélectionnée. La donnée est lue en mesurant le potentiel de la ligne RBL sélectionnée en entrée ou sortie de ligne.

La source de courant 111-9 a une borne au potentiel d'alimentation $V_{DD}$. Le choix ou adressage d'une cellule d'indices i entre 1 et n et k entre 1 et m se fait

- par basculement d'un organe de commutation SW d'indice i du dispositif d'adressage 110 et du circuit de polarisation 120 de ON pour une ligne mémoire sélectionnée à OFF pour une ligne non sélectionnée et vice versa - cet organe de commutation connecte la borne BL d'indice i aux sources de courant 111-0 et 111-1 et la borne BLB d'indice i au potentiel $V_{BLB}$ créé par une source de tension 121-0, et la borne RBL d'indice i à la source de courant 111-9,
- et l'application par le circuit d'adressage 130 à la borne WL d'indice k d'un potentiel $V_{WL}=V_{DD}$ le potentiel d'alimentation pour une colonne mémoire d'indice k sélectionnée. Si la colonne n'est pas sélectionnée, le potentiel de la borne WL $V_{WL}$ est inférieur ou égal à 0 V.

La source de tension 121-0 est, dans ce mode de réalisation, l'unique ou la principale source de tension de l'alimentation en tension 121 du circuit de polarisation 120 définie en relation avec la figure 5. Elle fournit un potentiel $V_{BLB}$ défini vis-à-vis de la masse GND.

Ces principes sont transposables à la structure SOT-SBL, en tenant compte des commentaires suivants :
Le choix ou adressage d'une cellule d'indices i entre 1 et n et k entre 1 et m se fait

- par basculement d'un organe de commutation SW d'indice i du dispositif d'adressage 110 et du circuit de polarisation 120 de ON pour une ligne mémoire sélectionnée à OFF pour une ligne non sélectionnée et vice versa - cet organe de commutation connecte la borne BL d'indice i aux sources de courant 111-0 et 111-1 et la borne BLB d'indice i au potentiel $V_{BLB}$ créé par une source de tension 121-0, et la borne RBL d'indice i à la source de courant 111-9,
- et l'application par le circuit d'adressage 130 à la borne WL d'indice k d'un potentiel $V_{WL}=V_{DD}$ le potentiel d'alimentation pour une colonne mémoire d'indice k sélectionnée. Si la colonne n'est pas sélectionnée, le potentiel de la borne WL $V_{WL}$ est inférieur ou égal à 0 V.

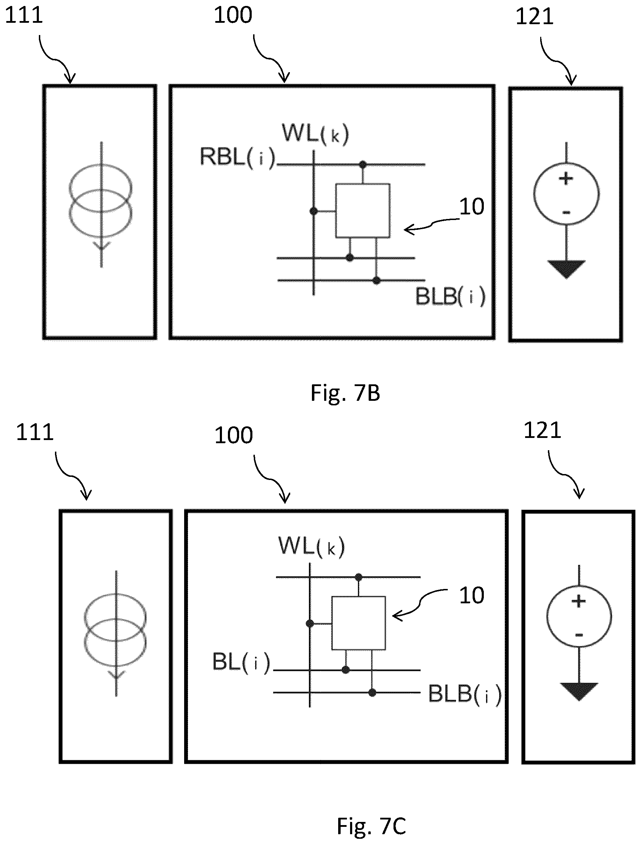

[Fig. 7B] Si seule la lecture est prévue, le terminal BL (ou éventuellement le terminal BLB) peut ne pas être utilisé et par exemple laissé flottant (BL n'est par conséquent pas représenté sur la figure 7B), et comme montré à la figure 7B, on a un terminal (WL(k)) de chaque cellule relié dans le circuit pour la sélection de cellules de la matrice selon une première dimension de la matrice à l'aide du transistor, ou des transistors, de la cellule servant de moyens de sélection de la connexion, et une paire de terminaux (BLB(i), RBL(i)) de chaque cellule reliée dans le circuit pour permettre une application commune, à des cellules de la matrice sélectionnées selon une deuxième dimension de la matrice, d'une énergie électrique pour la lecture d'une information binaire dans la cellule.

[Fig. 7C] Si seule l'écriture est prévue, le terminal RBL peut ne pas être utilisé, et comme montré à la figure 7C, on a un terminal (WL(k)) de chaque cellule relié dans le circuit pour la sélection de cellules de la matrice selon une première dimension de la matrice à l'aide du transistor, ou des transistors, de la cellule servant de moyens de sélection de la connexion, et une paire de terminaux (BL(i), BLB(i)) de chaque cellule reliée dans le circuit pour permettre une application commune, à des cellules de la matrice sélectionnées selon une deuxième dimension de la matrice, d'une énergie électrique pour l'écriture d'une information binaire dans la cellule.

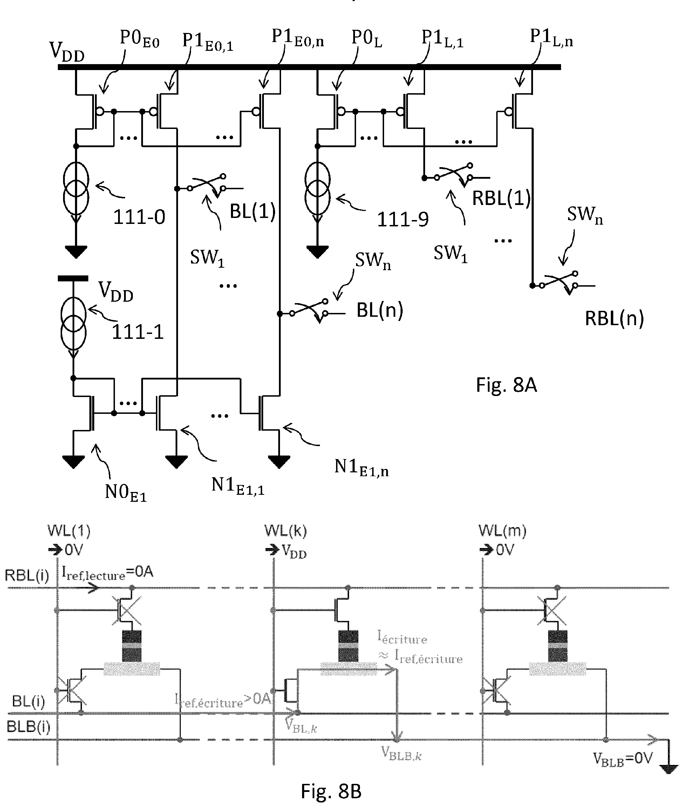

[Fig. 8A] Le circuit de pilotage en courant peut être réalisé de la manière suivante, représentée à titre non limitatif en figure 8A. Il y a mise en place de
Pour l'écriture :

- des miroirs de courant PMOS fondés sur un unique transistor PMOS $P0_{E0}$ et n transistors $P1_{E0,1}$ à $P1_{E0,n}$ tous en miroirs avec $P0_{E0}$ pour injecter du courant (Ecriture de la valeur '0') dans la ligne BL,

- et de miroirs de courant NMOS fondés sur un unique transistor NMOS $N0_{E1}$ et n transistors $N1_{E1,1}$ à $N1_{E1,n}$ tous en miroirs avec $N0_{E1}$ pour tirer du courant (Ecriture de la valeur '1') de la ligne BL.

Pour tout i entre 1 et n les bornes libres des transistors $P1_{E0,i}$ et $N1E_{1,i}$ (les branches de recopie) sont reliées entre elles et reliées, par le commutateur $SW_i$ au terminal BL(i) de la cellule d'indice i.

La source de courant 111-0 est placée entre le potentiel d'alimentation $V_{DD}$ et le potentiel de masse (GND), le transistor PMOS $P0_{E0}$ étant intercalé par sa source et son drain entre l'alimentation $V_{DD}$ et la source de courant 111-0. Quand la source de courant 111-0 est activée, la ligne BLB(i) est mise au potentiel 0V (GND), ce qui permet la circulation du courant de BL(i) vers BLB(i).

La source de courant 111-1 est placée entre le potentiel d'alimentation $V_{DD}$ et le potentiel de masse (GND), le transistor NMOS $N0_{E1}$ étant intercalé par son drain et sa source entre la source de courant 111-1 et la masse. Quand la source de courant 111-1 est activée, la ligne BLB(i) est mise au potentiel $V_{DD}$, ce qui permet la circulation du courant de BLB(i) à BL(i).

Pour la lecture :

- des miroirs de courant PMOS fondés sur un unique transistor PMOS $P0_L$ et n transistors $P1_{L,1}$ à $P1_{L,n}$ tous en miroirs

EP 4 712 078 A1

avec $P0_L$ pour injecter du courant dans la ligne RBL (lecture).

Pour tout i entre 1 et n la borne libre du transistor $P1_{L,i}$ (la branche de recopie) est reliée par le commutateur $SW_i$ au terminal RBL(i) de la cellule d'indice i.

La source de courant 111-9 est placée entre le potentiel d'alimentation $V_{DD}$ et le potentiel de masse (GND), le transistor PMOS $P0_L$ étant intercalé par sa source et son drain entre l'alimentation $V_{DD}$ et la source de courant 111-9. Quand la source de courant 111-9 est activée, la ligne BLB(i) est mise au potentiel 0V, ce qui permet la circulation du courant de RBL(i) à BLB(i).

Le fonctionnement du circuit de pilotage est alors fondé sur le fait qu'une cellule mémoire est sélectionnée quand elle est à l'intersection entre une ligne mémoire sélectionnée et une colonne mémoire sélectionnée.

Une colonne mémoire est sélectionnée si la tension du terminal WL correspondante, $V_{WL,k}$, pour une colonne k, est supérieure à la tension de seuil des transistors NMOS N1, pour l'écriture, et/ou N2, pour la lecture, des cellules mémoires 2T1R : typiquement, $\cdot\textbf{V}_{\textbf{WL,sélectionnée}}\textbf{=V}_{\textbf{DD}}\textbf{,}$ mais il est aussi possible d'utiliser différentes tensions.

Une colonne mémoire est non sélectionnée si la tension de WL correspondante, $V_{WL}$, pour une colonne k, est inférieure à la tension de seuil des transistors NMOS N1 et N2 des cellules mémoires 2T1R : typiquement, $\textbf{V}_{\textbf{WL ,non-sélectionnée}}\textbf{=0}\cdot V,,$ mais il est possible d'utiliser différentes tensions, comme par exemple des tensions négatives pour les colonnes non sélectionnées, ce qui est avantageux pour limiter les courants de fuite. D'autres tensions cette fois-ci positives, pas trop élevées néanmoins, peuvent être utilisées pour les colonnes non sélectionnées.

Une ligne mémoire d'indice i est non sélectionnée si le commutateur $SW_i$ est sur OFF

- elle fait l'objet d'une écriture de la valeur 0 si $I_{ref,écriture,0}$ >0A et $V_{BLB}$ = 0 V ou éventuellement une tension négative
- elle fait l'objet d'une écriture de la valeur 1 si $I_{ref,écriture,1}$ >0A et $V_{BLB}$ = $V_{DD}$
- elle fait l'objet d'une lecture si $I_{ref,lecture}$ >0A et et $V_{BLB}$ = 0 V ou éventuellement une tension négative.

Le courant d'écriture dans une cellule mémoire sélectionnée se caractérise par les observations suivantes, basées sur des simulations avec $\textbf{I}_{\textbf{ref,écriture}}\textbf{=300}\mu\textbf{A,}$ RA=20 $\Omega.\mu m^2$, $R_{SOT} \approx 300\,\Omega$ : pendant une opération d'écriture '0' ou '1', le courant d'écriture, $\textbf{I}_{\textbf{écriture}}\textbf{,}$ qui circule dans la cellule mémoire sélectionnée est constant et indépendant de la position de celle-ci ($\approx I_{ref,écriture}$). $I_{écriture}$ ne circule que dans la ligne SOT et les courants de fuite MTJ sont nuls (<0.5 $\mu A$). $I_{écriture}$ n'est pas affecté par les résistances parasites de routage (tant qu'elles sont inférieures, du moins, à 0.5 $\Omega$/cellule - cette valeur de résistance parasite de routage de 0,5 $\Omega$/cellule, correspond aux parasites sur les lignes BL et BLB - supposés égaux dans les simulations. La résistance parasite de routage de la ligne RBL n'a pas d'impact, étant donné que le courant d'écriture circule seulement à travers BL et BLB. Elle est fixée à 3,5 $\Omega$/cellule dans toutes les simulations, ce qui correspond à un scénario pire cas avec une ligne de routage RBL de largeur minimale et aux courants de fuite dans les cellules mémoires non sélectionnées. Il n'y a pas de dégradation du pilier MTJ $(\textbf{V}_{\textbf{MTJ}}\approx\textbf{0V}).$ Il n'y a pas d'asymétrie entre l'écriture '0' et l'écriture '1'. Toutefois, il est également possible de faire circuler des courants d'écriture '0' et '1' d'amplitudes différentes dans la cellule mémoire sélectionnée, en utilisant des valeurs de $I_{ref,écriture,0}$ et $I_{ref,écriture,1}$ différentes l'une de l'autre.

La tension de lecture pendant une opération de lecture se caractérise également par les observations suivantes, basées sur des simulations avec des paramètres identiques et $\textbf{I}_{\textbf{ref,lecture}}\textbf{=10}\mu\textbf{A}$ : pendant une opération de lecture à courant constant, le circuit de pilotage en courant injecte un faible courant de lecture constant, $I_{ref,lecture}$, à travers la cellule mémoire à lire - la ligne RBL sélectionnée se charge à une tension $V_{lecture,0/1}$ qui dépend de la donnée lue ('0' ou '1', respectivement), et pour $I_{ref,lecture}$=10 $\mu A$, $V_{lecture,0}\approx$175 mV si la donnée lue est '0', et $V_{lecture,1}\approx$325 mV si la donnée lue est '1. La lecture est donc fonctionnelle puisque la différence $\Delta V_{lecture}$ est d'environ 150 mV, ce qui est suffisant pour distinguer les données. $V_{lecture,0/1}$ est constant quelle que soit la position de la cellule mémoire lue. La valeur de $V_{lecture,0/1}$ est très peu sensible aux résistances parasites de routage $R_{RBL,par}$>3.5 $\Omega$/cellule car $I_{ref,lecture}$ est faible, et il n'y a pas de dégradation du pilier MTJ car $V_{MTJ}$<0.4 V, ni non plus d'écriture parasite par STT puisque $I_{MTJ}\approx I_{ref,lecture}$. La résistance parasite de la ligne d'accès RBL est toujours fixée à 3.5 $\Omega$/cellule dans cette simulation et a peu d'impact sur l'opération de lecture car le courant de lecture est faible. Les résistances parasites des lignes BL et BLB ont également peu d'impact sur la lecture (elles peuvent monter ·jusqu'à plus d'1 $\Omega$/cellule sans impact sur les tensions de lecture).

On rappelle à ce stade que l'invention s'applique aussi avec d'autres structures de cellules mémoires SOT-MRAM impliquant au moins deux composants de sélection par cellule mémoire, connectés à deux terminaux différents. L'invention s'applique à la structure SOT-SBL car on ne fait pas circuler de courant simultanément dans la ligne SOT et le pilier MTJ : l'écriture et la lecture sont séparées. On connecte la source de courant de RBL sur BL.

[Fig. 8B] Ainsi, pour une écriture de la donnée '0', il est représenté en figure 8B, l'injection d'un courant $I_{ref,écriture}$ de BL vers BLB avec polarisation du terminal BLB à 0V.

Cela est fait en sélectionnant une cellule mémoire de la ligne mémoire (cellule mémoire k, le terminal WL reçoit un potentiel égal à la tension d'alimentation $V_{WL,}=V_{DD}$) et en désélectionnant les autres cellules mémoires ($V_{WL}$=0V, le terminal WL reçoit le potentiel de la masse). $I_{ref,écriture}$ circule alors majoritairement au travers de la cellule mémoire sélectionnée, en tenant compte des courants de fuite.

Les potentiels aux bornes BL et BLB de la cellule mémoire sélectionnée, $V_{BL}$, et $V_{BLB}$, s'ajustent afin de garantir la circulation du courant $I_{ref,écriture}$ au travers de la cellule mémoire sélectionnée.

| | Ligne(s) mémoire *i* sélectionnée(s) | | | Lignes mémoire non sélectionnées |
|---|---|---|---|---|
| | Écriture '0' | Écriture '1' | Lecture | Écriture/Lecture |
| $SW_i$ | ON | | | OFF |
| $I_{ref,écriture,0}$ | $I_{ref,écriture}$>0 A | 0 A | 0 A | / |
| $I_{ref,écriture,1}$ | 0 A | $I_{ref,écriture}$>0 A | 0 A | / |
| $I_{ref,lecture}$ | 0 A | 0 A | $I_{ref,lecture}$>0 A | / |
| $V_{BLB}$ | 0 V | $V_{DD}$ | 0 V | / |

Pour désélectionner une ligne mémoire d'indice i on bascule le commutateur $SW_i$ à OFF (ouvert). Pour sélectionner une ligne mémoire d'indice i on bascule le commutateur $SW_i$ à ON (fermé).

Pour l'écriture de la donnée '0', la source de courant 111-0 est activée avec un courant positif non nul $I_{ref,écriture,0}$ >0A, et les sources de courant 111-1 et 111-9 sont coupées : $I_{ref,écriture,1}$ = $I_{ref,lecture}$ = 0A. Le potentiel $V_{BLB}$ du terminal BLB est relié à la masse (0V).

Pour désactiver le miroir de courant d'écriture '1' (correspondant au cas $I_{ref,écriture,1}$ = 0 A), on utilise un interrupteur sur la connexion entre la source de courant 111-1 et la grille du transistor $N_{0,E1}$. Lorsque le miroir de courant d'écriture '1' est utilisé, cet interrupteur permet la connexion entre la source de courant et la grille du transistor (comme sur le figure 8A). Lorsque le miroir de courant d'écriture '1' est désactivé (i.e. $I_{ref,écriture,1}$ = 0 A), l'interrupteur déconnecte la source de courant 111-1 et la grille du transistor $N_{0,E1}$, et connecte cette grille à GND.

Pour les miroirs de courant de type PMOS, un principe similaire est appliqué, la désactivation se faisant en connectant les grilles à l'alimentation $V_{DD}$, pour bloquer les transistors PMOS.

Pour l'écriture de la donnée '1', la source de courant 111-1 est activée avec un courant positif non nul $I_{ref,écriture,1}$ >0A, et les sources de courant 111-0 et 111-9 sont coupées : $I_{ref,écriture,0}$ = $I_{ref,lecture}$ = 0A. Le potentiel $V_{BLB}$ du terminal BLB est relié à l'alimentation ($V_{DD}$).

Les courants fournis par les sources 111-0 et 111-1 pour l'écriture de la donnée '0' et de la donnée '1' peuvent être sensiblement de même intensité, ou d'intensité sensiblement différentes.

Pour la lecture de la donnée, la source de courant 111-9 est activée avec un courant positif non nul $I_{ref,lecture}$ >0A, et les sources de courant 111-0 et 111-1 sont coupées : $I_{ref,écriture,0}$ = $I_{ref,écriture,1}$ = 0A. Le potentiel $V_{BLB}$ du terminal BLB est relié à la masse (0V).

Les cellules mémoires sélectionnées sont identifiées comme les intersections entre les lignes mémoire sélectionnées (il peut y en avoir une seule ou plusieurs simultanément) et les colonnes mémoire sélectionnées (il n'y en a qu'une seule, dans le mode de réalisation présenté des figures 6 et 8B, mais éventuellement sous certains ajustements il peut y en avoir plusieurs simultanément).

Les colonnes mémoire sélectionnées sont définies par le fait que le potentiel du terminal WL correspondant, $V_{WL}$, (pour une colonne k) est supérieur à la tension de seuil des transistors NMOS N1 (pour l'écriture) et/ou N2 (pour la lecture) des cellules mémoires 2T1R : typiquement, **$V_{WL,nonsélectionnée}$ = $V_{DD}$** (mais il est possible d'utiliser différents potentiels).

Les colonnes mémoire non sélectionnées sont identifiés par le fait que le potentiel du terminal WL correspondant, $V_{WL}$, (pour une colonne k), est inférieur au potentiel de seuil des transistors NMOS N1 et N2 des cellules mémoires 2T1R. Typiquement, **$V_{WL,nonsélectionnée}$** =0 V (il est possible d'utiliser différentes tensions, par exemple négatives).

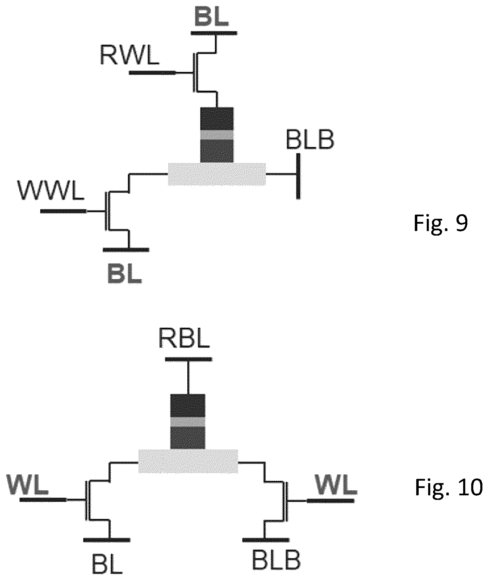

[Fig. 9] Il est aussi prévu d'utiliser la cellule SOT-SBL (4T) représentée en figure 9. Dans un mode de réalisation avec écriture et lecture mises en œuvre de façon séparée, et non simultanée, l'invention est applicable à la structure SOT-SBL. On connecte la source de courant de lecture 111-9 sur le même terminal commun que les sources de courant d'écriture 111-0 et 111-1.

[Fig. 10] Il est aussi prévu d'utiliser la cellule SOT-SWL2 (4T) représentée en figure 10. De même, la cellule SOT-5T de la figure 3 est compatible avec l'invention.

Il est également prévu, dans des variantes, d'utiliser d'autres organisations matricielles, avec au moins deux lignes transversales deux à deux.

Il est prévu, dans un mode de réalisation, d'utiliser du body-bias (application d'un potentiel non nul à un caisson du circuit) et/ou des tensions de lignes de mots WL différentes pour l'adressage des colonnes mémoires.

Il est aussi prévu, dans un mode de réalisation, d'intervertir les positions du circuit de pilotage en courant et du circuit de polarisation, les deux circuits devant être en opposition par rapport à la matrice mémoire, aux deux extrémités des lignes de bits BL, RBL et BLB.

Il est aussi prévu, dans un mode de réalisation, de garder une source de tension sur la ligne RBL. Dans ce mode de réalisation, l'écriture est similaire. Toutefois, pour la lecture, on effectue une lecture à tension constante (ie. le courant de lecture circulant à travers le pilier MTJ varie selon la donnée lue).

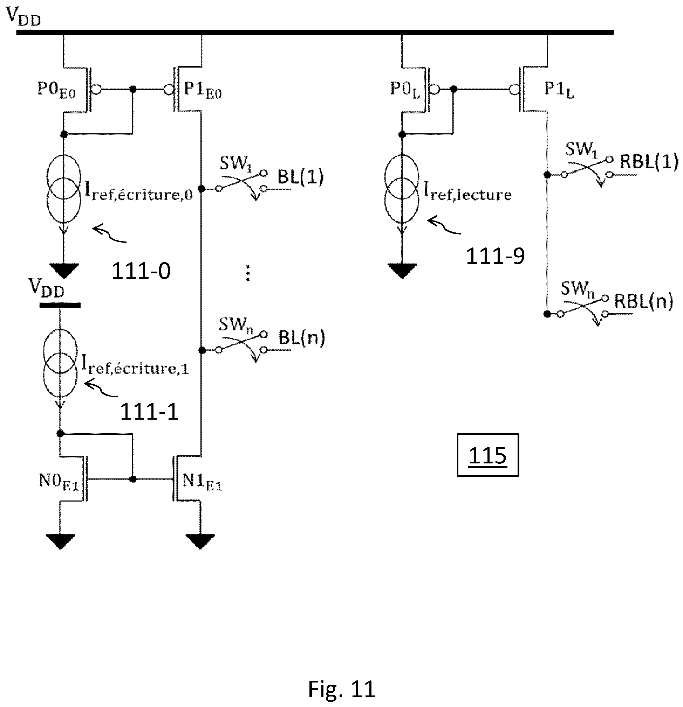

[Fig. 11] Il est également prévu des variantes relatives au circuit de pilotage en courant.

On n'adresse, dans le montage de la figure 11, alternative à celui de la figure 8A, à chaque fois qu'une seule ligne mémoire à la fois (et non potentiellement plusieurs en même temps), ce qui offre la possibilité d'utiliser une seule branche de recopie par miroir de courant pour l'ensemble de la matrice (au lieu d'une branche de recopie par ligne mémoire), ce qui permet de simplifier le circuit de pilotage. Le choix d'une unique ligne à adresser est effectué sous le contrôle du contrôleur 115 du dispositif d'adressage 110 (voir figure 5). Si plusieurs lignes sont à adresser, le contrôleur 115 fait le choix de les traiter séquentiellement, par exemple (là où avec le circuit de la figure 8A cela pouvait être fait simultanément).

Ainsi, il y a une seule branche de recopie par miroirs de courant connectée à n interrupteurs (BL(1), ..., BL(n) ; RBL(1), ..., RBL(n)), ce qui offre une simplification du circuit par comparaison au circuit de la figure 8A : on passe de n branches de recopie par miroirs de courant à une seule branche.

Il y a donc mise en place de

- un miroir de courant PMOS fondé sur un unique transistor PMOS $P0_{E0}$ et un unique transistor $P1_{E0}$ en miroir avec $P0_{E0}$ pour injecter du courant (Ecriture de la valeur '0'),

- et de un miroir de courant NMOS fondé sur un unique transistor NMOS $N0_{EL}$ et un unique transistor $N1_{E1}$ en miroir avec $N0_{E1}$ pour tirer du courant (Ecriture de la valeur '1').

Les bornes libres des transistors $P1_{E0}$ et $N1_{E1}$ (les branches de recopie) sont reliées entre elles, et pour tout i entre 1 et n sont reliées, par le commutateur $SW_i$ au terminal BL(i) de la cellule sélectionnée de la ligne d'indice i.

Il y a mise en place de miroirs de courant PMOS fondés sur un unique transistor PMOS $P0_L$ et un unique transistor $P1_L$ en miroir avec $P0_L$ pour injecter du courant (lecture). Pour tout i entre 1 et n la borne libre du transistor $P1_L$ (la branche de recopie) est reliée par le commutateur $SW_i$ au terminal RBL(i) de la cellule sélectionnée de la ligne d'indice i.

Les sources de courant 111-0, 111-1 et 111-9 sont placées de la même manière que dans le mode de réalisation de la figure 8A.

Pour conclure ces commentaires liés à la figure 11, on précise que le montage de cette figure est compatible avec la structure SOT-SBL, mais dans ce cas le miroir de courant avec 111-9 est connecté au terminal BL au lieu du terminal RBL.

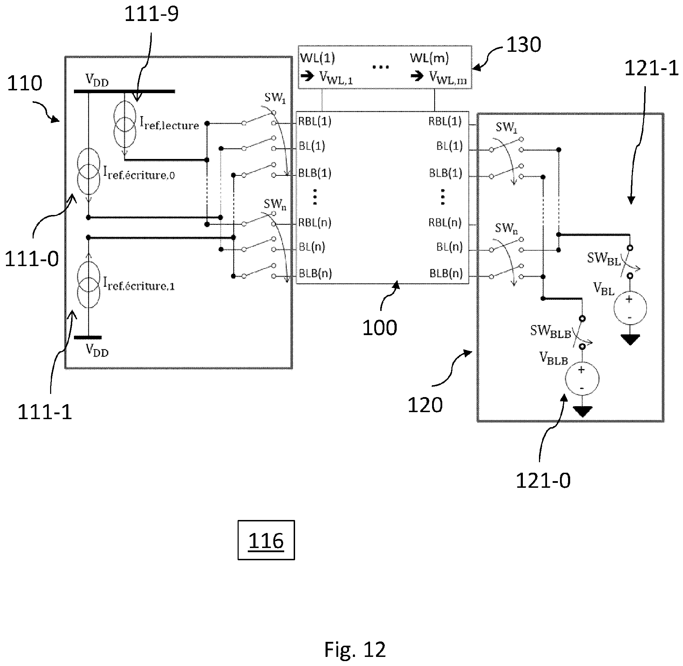

[Fig. 12] En figure 12, on a représenté une variante dans laquelle on déconnecte l'une de l'autre les deux sources de courant connectées aux terminaux BL dans le mode de réalisation de la figure 6, à savoir la source 111-0 et la source 111-1. De plus on inverse les deux pôles de la source de courant 111-1. Enfin, on connecte celle-ci sur, cette fois, les terminaux BLB.

Cela implique d'ajouter, à côté de la source de tension 121-0, une source de tension 121-1 fournissant un potentiel $V_{BL}$ sur les terminaux BL en bout de matrice pour la polarisation. Ce potentiel $V_{BL}$ est appliqué via un interrupteur global $SW_{BL}$ (optionnel) et les interrupteurs particuliers $SW_i$ avec i de 1 à n commandant simultanément l'application du potentiel $V_{BLB}$ à la ligne BLB(i) et du potentiel $V_{BL}$ à la ligne BL(i), ainsi que de la source de courant 111-0 au terminal BL(i), de la source de courant 111-1 au terminal BLB(i), et de la source de courant 111-9 au terminal RBL(i). Les potentiels $V_{BL}$ et $V_{BLB}$ sont appliqués sous le contrôle d'un contrôleur 116 du circuit d'adressage 110.

Ce montage permet de n'utiliser qu'un seul type de miroir de courant, en l'occurrence des miroirs PMOS dans le montage de la figure 12. On utilise la même branche de référence pour tous les miroirs de courant de l'ensemble de la matrice. Les branches de recopie sont dimensionnées selon les valeurs visées de $I_{ref,écriture,0}$, $I_{ref,écriture,1}$, et $I_{ref,lecture}$.

Les sources de tension 121-0 et 121-1 sont, dans ce mode de réalisation, les sources de tension de l'alimentation en tension 121 du circuit de polarisation 120 évoquée en relation avec la figure 5. Elles fournissent les potentiels $V_{BLB}$ et $V_{BL}$ définis vis-à-vis de la masse GND.

Pour conclure ces commentaires liés à la figure 12, on précise que le montage de cette figure est compatible avec la structure SOT-SBL, mais dans ce cas la source de courant 111-9 est connectée au terminal BL au lieu du terminal RBL.

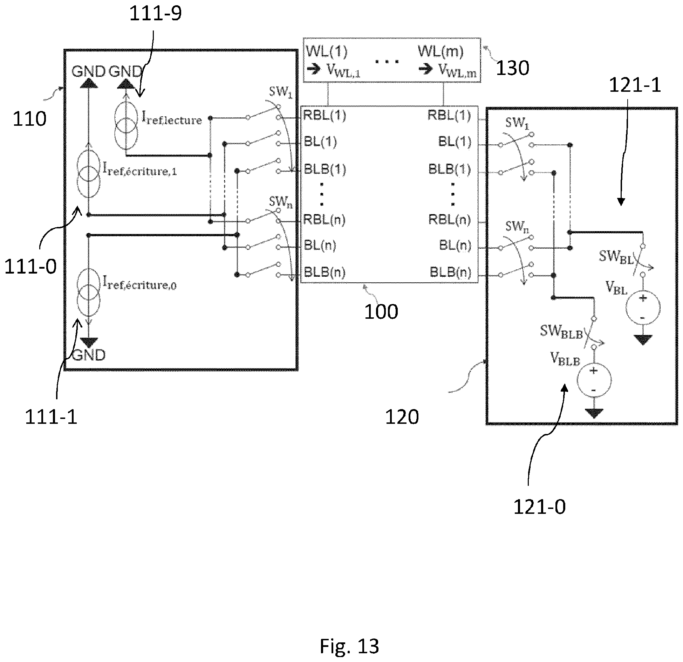

[Fig. 13] En figure 13, on a représenté une variante dans laquelle on inverse les deux pôles de la source de courant 111-0 ainsi que les deux pôles de la source de courant 111-1 et également les deux pôles de la source de courant 111-9 par rapport au mode de réalisation de la figure 12.

Ce montage permet de n'utiliser qu'un seul type de miroir de courant, mais de type NMOS.

Pour conclure ces commentaires liés à la figure 13, on précise que le montage de cette figure est compatible avec la structure SOT-SBL, mais dans ce cas la source de courant 111-9 est connectée au terminal BL au lieu du terminal RBL.

Les variantes présentées ci-après sont applicables aux cellules SOT-5T, SOT-SWL1 et SOT-SWL2.

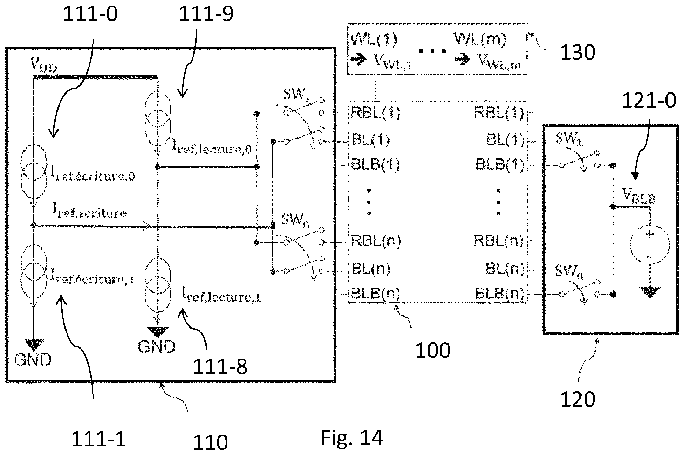

[Fig. 14] En figure 14, on a représenté une variante, dans laquelle, partant du mode de réalisation de la figure 7A, on ajoute une deuxième source de courant sur le terminal RBL.

La source de courant 111-8 placée, aux fins de la figure, entre la masse et le pôle opposé à l'alimentation de la source de courant 111-9, tire un courant du terminal RBL(i), quand le commutateur $SW_i$ est fermé.

Cela rend possible d'effectuer simultanément une opération de lecture et d'écriture sur une cellule mémoire sélectionnée, ce qui est utile pour effectuer du « write-verify » en un seul cycle d'horloge, c'est-à-dire vérifier que la cellule mémoire a bien commuté avec l'opération d'écriture, sinon quoi on retente l'écriture de la donnée, ou vérifier en temps réel le moment de commutation, ou encore pour certaines applications de calculs dans la mémoire (opérations dites « in-memory computing »).

Lors d'une écriture '0', on active la source de courant 111-0 pour effectuer l'écriture classique, et on active également la source de courant 111-9 (comme pour effectuer une lecture classique). Le terminal BLB(i) est polarisé en bout de ligne à 0V. Le courant d'écriture généré par la source de courant 111-0 ne circule que dans la ligne SOT LSOT de la cellule mémoire sélectionnée (de BI(i) vers BLB(i)), et le courant de lecture généré par la source de courant 111-9 ne circule que dans le pilier MTJ de la cellule mémoire sélectionnée (de RBL(i) vers BLB(i)).

En sortie de la ligne LSOT (terminal BLB(i)), les deux courants (écriture '0' et lecture) s'additionnent. Cependant, comme le courant de lecture est faible par rapport au courant d'écriture (e.g. : 30 fois plus faible dans les simulations pour $I_{ref,écriture,0}$ = 300µA et $I_{lecture}$ = 10 µA), cela n'a pas d'impact sur l'opération d'écriture (ie. on effectue bien une écriture '0' comme décrit précédemment).

Simultanément, la circulation du courant de lecture dans le pilier MTJ polarise la ligne RBL(i) a une tension de lecture qui dépend de l'état de magnétisation du pilier MTJ (similaire à une lecture classique).

Lors d'une écriture '1', le principe est identique que pour l'écriture '0' : on active la source de courant 111-1 pour tirer du courant de la ligne BL(i) (comme pour une écriture '1' classique), et on active simultanément, cette fois-ci, la source de courant 111-8 (qui tire du courant de RBL(i)) au lieu de la source de courant 111-9 (qui injecte du courant dans RBL(i)). Comme la ligne BLB(i) est polarisée en bout de ligne à $V_{DD}$ lors d'une écriture '1', il est préférable d'utiliser la source de courant 111-8 plutôt que la source de courant 111-9 à cause des niveaux de tension : il est plus simple, pour la lecture, de tirer du courant de BLB(i) vers RBL(i) que d'en injecter à cause de la polarisation à $V_{DD}$ en bout de ligne BLB(i).

Les variantes des figures 12 et 13 permettent également d'effectuer l'écriture et la lecture simultanément.

Par exemple pour le montage de la figure 12, de façon identique à ce qui est mis en œuvre pour le montage de la Figure 14, pour une écriture '0' on active la source de courant d'écriture 111-0, et simultanément on active la source de courant de lecture 111-9. De même, pour une écriture '1', on active la source de courant d'écriture 111-1, et simultanément la source de courant de lecture 111-9. Dans le cas de la Figure 12, on polarise toujours en bout de ligne à GND (si on est en écriture '0', on polarise BLB(i) en bout de ligne à 0V; si on est en écriture '1', on polarise BL(i) en bout de ligne à 0V). Contrairement au cas de la figure 14, comme le niveau de tension en bout de ligne est toujours 0V, on n'a plus besoin d'ajouter une 2$^{éme}$ source de courant sur RBL : dans les deux cas d'écriture, on injecte toujours du courant dans RBL. Pour le comparateur du circuit de lecture, il se peut qu'il y ait besoin de deux niveaux de tensions de référence différents pour l'écriture '0' et l'écriture '1' (et cela est vrai aussi pour le mode de réalisation de la figure 14).

Pour le montage de la figure 13, on met en œuvre le même principe de fonctionnement que pour la figure 12 (on polarise néanmoins en bout de ligne à $V_{DD}$ au lieu de GND), et les mêmes commentaires sont valables. On n'utilise que des sources qui tirent du courant des lignes.

Par ailleurs, comme cela va être développé ci-après, en implémentant deux sources de courant par ligne d'accès (BL, BLB, et RBL), il est possible d'assister les opérations d'écriture avec du courant STT spin-transfer torque (pour des piliers MTJ à faible valeur RA, ie. faibles valeurs de résistance). Cela permet également d'effectuer simultanément l'écriture et la lecture. L'implémentation de deux sources de courant par ligne d'accès permet, en premier lieu, d'assister l'écriture par courant STT. De plus, cette implémentation offre également la possibilité d'effectuer l'écriture et la lecture simultanément, éventuellement en utilisant plusieurs tensions de référence.

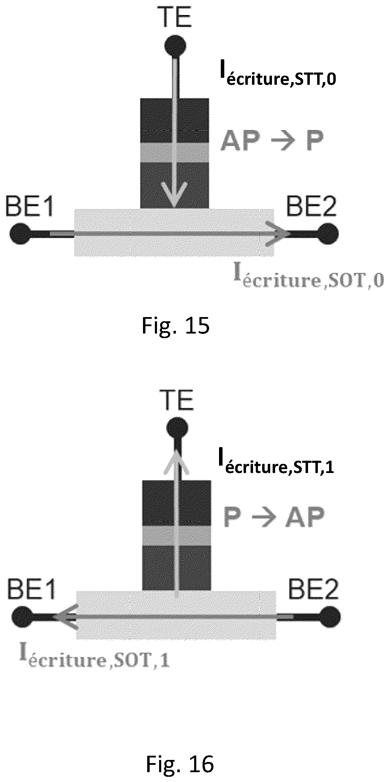

[Fig. 15] En figures 15 et 16, on explique le principe de fonctionnement de l'écriture avec assistance d'un courant STT. Ce sujet est abordé dans l'article E. Grimaldi et al., « Single-shot dynamics of spin-orbit torque and spin transfer torque switching in three-terminal magnetic tunnel junctions », in Nature Nanotechnology, 15(2):111-117, 2020, et également dans EP3671749A1.

Pour l'opération d'écriture de la donnée '0', en plus du courant d'écriture classique circulant à travers la ligne SOT, $I_{écriture,SOT,0}$ un courant d'écriture STT, $I_{écriture,STT,0}$ circule également à travers le pilier MTJ, sur la figure 15 de la borne TE vers la ligne SOT, pendant une opération d'écriture '0'. Cela est représenté en figure 15.

[Fig. 16] Et pour l'opération d'écriture de la donnée '1', en plus du courant d'écriture classique circulant à travers la ligne SOT, $I_{écriture,SOT,1}$ un courant d'écriture STT $I_{écriture,STT,1}$ circule également à travers le pilier MTJ, sur la figure de la ligne SOT vers la borne TE, pendant une opération d'écriture '1'. Cela est représenté en figure 16.

L'écriture par STT est bipolaire, le sens de circulation du courant STT dépendant en effet de la donnée à écrire.

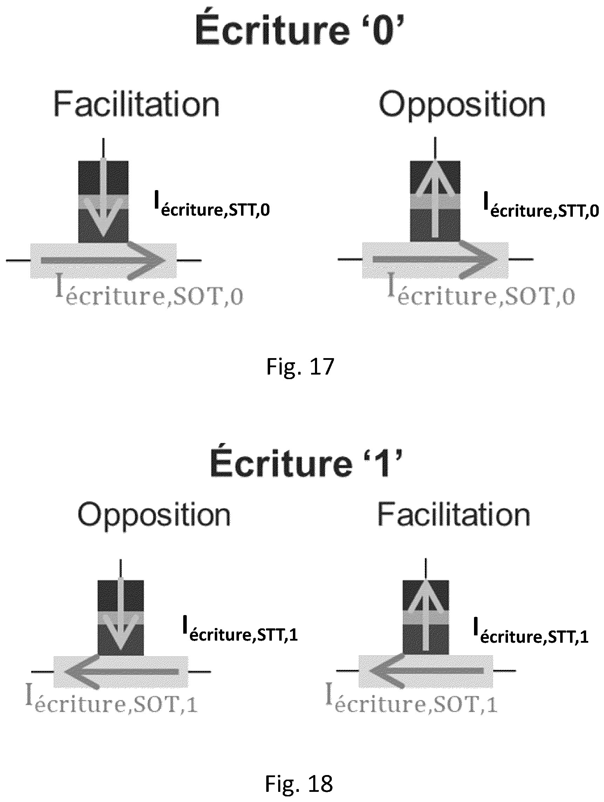

[Fig. 17] Le courant STT facilite l'écriture '0' en circulant dans un sens (par exemple du haut vers le bas du pilier MTJ comme en figure 15 et en partie gauche de la figure 17).

[Fig. 18] Le courant STT facilite l'écriture '1' en circulant dans l'autre sens (par exemple du bas vers le haut du pilier MTJ, comme en figure 16 et en partie droite de la figure 18).

Mais il est aussi possible d'utiliser le courant STT pour s'opposer à l'écriture, le courant STT circulant dans le sens opposé à la facilitation en fonction de la donnée à écrire, pour par exemple sélectionner un pilier dans une structure multi-piliers.

Le courant STT s'oppose à l'écriture '0' en circulant dans l'autre sens, à savoir du bas vers le haut du pilier MTJ en partie droite de la figure 17.

Le courant STT s'oppose à l'écriture '1' en circulant dans l'autre sens, à savoir du haut vers le bas du pilier MTJ en partie gauche de la figure 18.

L'écriture avec assistance STT nécessite que la valeur du produit résistance-aire RA du pilier MTJ soit faible, typiquement inférieur à 20 $\Omega.\mu m^2$.

Le courant d'écriture STT, $I_{écriture,STT,0/1}$, permet de réduire le courant d'écriture par SOT, $I_{écriture,SOT,0/1}$, nécessaire, lorsqu'il y a facilitation, ou, à l'inverse, augmenter le courant d'écriture par SOT nécessaire lorsqu'il y a opposition.

Il est nécessaire, pour mettre en place cette fonctionnalité de contrôler les sens de circulation des courants d'écriture SOT et STT de façon indépendante.

Certains circuits mémoires SOT-MRAM utilisant l'écriture avec assistance d'un courant STT sont pilotés avec des sources de tension constante pour générer le courant d'écriture SOT, $I_{écriture,SOT}$, et le courant d'écriture STT, $I_{écriture,STT}$ :

Les courants d'écriture SOT et STT sont souvent non uniformes au sein de la matrice mémoire, avec une diminution des courants à mesure que l'on s'éloigne des circuits de pilotage, et une asymétrie entre l'écriture '0' et '1'.

De plus, il est difficile de contrôler précisément et indépendamment les chemins de circulation des courants d'écriture SOT et STT : pour être en mesure de faciliter ou s'opposer à l'écriture indépendamment de la donnée à écrire ('0' ou '1'), $I_{écriture,STT}$ doit pouvoir circuler à travers le pilier MTJ dans les deux sens (du haut vers le bas, ou du bas vers le haut) indépendamment du sens de circulation de $I_{écriture,SOT}$ (dans la ligne SOT, de BL vers BLB ou BLB vers BL).

Le mode de réalisation présenté prévoit donc qu'au lieu de piloter la matrice mémoire en tension, on pilote la matrice mémoire entièrement en courant :

Le circuit de pilotage génère un courant d'écriture SOT de référence, $I_{ref,écriture,SOT}$, qui circule à travers la ligne SOT de la cellule mémoire sélectionnée

Le circuit de pilotage génère un courant d'écriture STT de référence, $I_{ref,écriture,STT}$, qui circule à travers le pilier MTJ de la cellule mémoire sélectionnée.

Les courants $I_{ref,écriture,SOT}$ et $I_{ref,écriture,STT}$ sont contrôlés indépendamment l'un de l'autre.

Le circuit de pilotage utilisé pour générer le courant d'écriture STT permet également d'effectuer les opérations de lecture.

La proposition de solution résout les problèmes rencontrés :

Les courants d'écriture SOT et STT circulant à travers la cellule mémoire sélectionnée, $I_{écriture,SOT}$ et $I_{écriture,STT}$, respectivement, sont constants quelle que soit la position de la cellule mémoire sélectionnée et la donnée à écrire ('0' ou '1') ($I_{écriture,SOT} \approx I_{ref,écriture,SOT}$ et $I_{écriture,STT} \approx I_{ref,écriture,STT}$). Ces deux courants ne sont pas dépendants de la position et de la donnée à écrire, mais dépendent seulement de $I_{ref,écriture,SOT}$ et $I_{ref,écriture,STT}$, respectivement

Les chemins de circulation de $I_{écriture,SOT}$ et $I_{écriture,STT}$ sont bidirectionnels et indépendants l'un de l'autre.

La solution proposée est d'implémenter au sein de la source de courant 111 (voir figure 5) des sources de courant STT en plus des sources de courant SOT déjà évoquées.

Le circuit de pilotage en courant comprend alors une source de courant qui génère $I_{ref,écriture,SOT}$, $I_{ref,écriture,STT}$, et $I_{ref,lecture}$, la composante de la source de courant générant $I_{ref,lecture}$ générant aussi $I_{ref,écriture,STT}$.

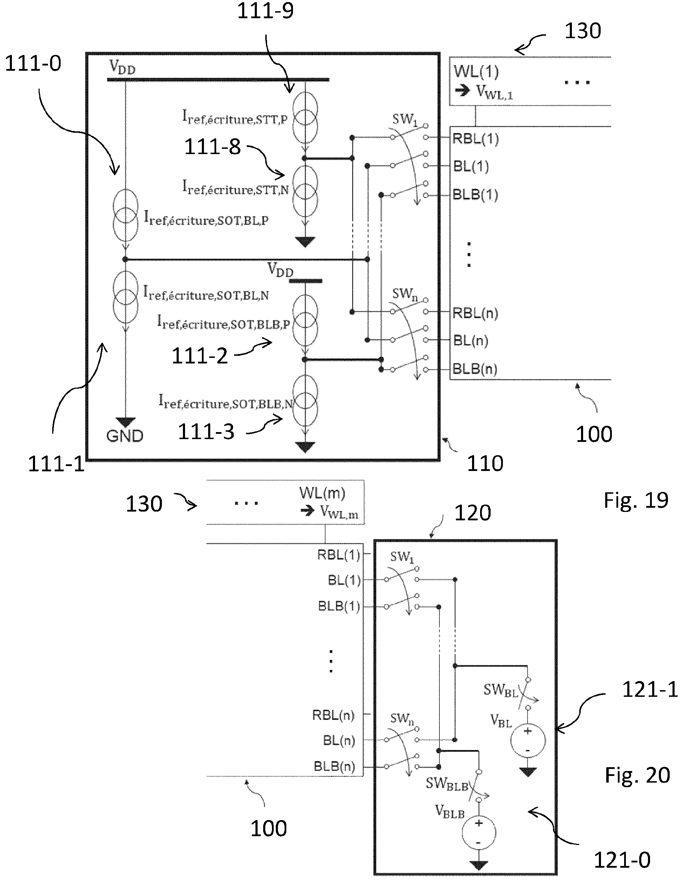

$I_{ref,lecture}$ et $I_{ref,écriture,STT}$ sont généralement à peu près de même amplitude ($I_{ref,lecture}$ -10-20 $\mu A$ et $I_{ref,écriture,STT}$ ~20-30 $\mu A$ dans notre cas). En particulier, $I_{ref,écriture,STT}$ seul ne peut pas écrire de données dans le pilier MTJ (l'écriture se fait par action conjointe de $I_{ref,écriture,SOT}$ et $I_{ref,écriture,STT}$). Ainsi, il est possible d'utiliser la structure de la Figure 19 (discutée ci-après) pour faire l'écriture mais aussi à un autre moment la lecture (i.e. pour la lecture, on peut utiliser une des deux sources de courant $I_{ref,écriture,STT,P}$ ou $I_{ref,écriture,STT,N}$ au choix, en désactivant toutes les sources de courant d'écriture SOT, et on effectue une lecture classique sans risque d'écriture parasite).

Si $I_{ref,écriture,STT}$ et $I_{ref,lecture}$ ont des amplitudes significativement différentes, on prévoit une source de courant supplémentaire sur RBL qui est spécifique à la lecture (une source de courant qui injecte ou tire du courant de RBL, l'une ou l'autre au choix).

Pour effectuer une lecture et une écriture simultanées, on utilise le même principe de fonctionnement que précédemment, en reconnaissant que le courant de lecture et le courant d'écriture STT sont le même courant dans le mode de réalisation de la figure 19 (discutée ci-après). Le circuit de lecture nécessite plusieurs tensions de référence selon la source de courant RBL activée.

Le circuit de pilotage en courant comprend aussi un dispositif d'adressage qui connecte la source de courant aux lignes mémoires sélectionnées (ie. RBL, BL, et BLB sélectionnées).

On utilise toujours un circuit de polarisation polarisant les lignes de bit à des tensions appropriées, comme précédemment, ainsi qu'un circuit d'adressage des lignes de mot qui sélectionne une colonne mémoire.

L'architecture est la même que celle présentée en figures 5 et 6.

[Fig. 19] En figure 19, l'implémentation du circuit de pilotage avec assistance STT répond aux principes suivants, pour la matrice mémoire 100 de type SOT-MRAM de m mots de chacun n bits.

Il est fondé sur un dispositif d'adressage 110, comprenant des sources de courant en nombre plus grand que précédemment. Elles sont détaillées ci-après.

L'écriture de la donnée se fait par

- l'injection du courant $I_{ref,écriture,SOT,BL,P}$, généré par une source de courant 111-0 dans la ligne BL sélectionnée (d'indice i du bit 1 au bit n), et ce courant circule de la ligne BL sélectionnée vers la ligne BLB sélectionnée (de même indice i) à travers la cellule mémoire sélectionnée,
- l'extraction du courant $I_{ref,écriture,SOT,BL,N}$ généré par une source de courant 111-1, de la ligne BL sélectionnée (d'indice i du bit 1 au bit n), le courant circulant de la ligne BLB sélectionnée vers la ligne BL sélectionnée (de même indice i) à travers la cellule mémoire sélectionnée,
- l'injection du courant $I_{ref,écriture,SOT,BLB,P}$, généré par une source de courant 111-2 dans la ligne BLB sélectionnée (d'indice i du bit 1 au bit n), et ce courant circule de la ligne BLB sélectionnée vers la ligne BL sélectionnée (de même indice i) à travers la cellule mémoire sélectionnée,
- l'extraction du courant $I_{ref,écriture,SOT,BLB,N}$ généré par une source de courant 111-3, de la ligne BLB sélectionnée (d'indice i du bit 1 au bit n), le courant circulant de la ligne BL sélectionnée vers la ligne BLB sélectionnée (de même indice i) à travers la cellule mémoire sélectionnée.

Les sources de courant 111-0 et 111-1 ont, aux fins de la figure 19, une borne commune, et leurs secondes bornes sont respectivement reliées à la tension d'alimentation $V_{DD}$ et à la masse GND.

Les sources de courant 111-2 et 111-3 ont, aux fins de la figure 19, une borne commune, et leurs secondes bornes sont respectivement reliées à la tension d'alimentation $V_{DD}$ et à la masse GND.

L'assistance STT à l'écriture se fait par

- l'injection du courant $I_{ref,écriture,STT,P}$, généré par une source de courant 111-9 dans la ligne RBL sélectionnée (d'indice i du bit 1 au bit n)
- et par extraction du courant $I_{ref,écriture,STT,N}$ généré par une source de courant 111-8, de la ligne RBL sélectionnée (d'indice i du bit 1 au bit n).

Les sources de courant 111-9 et 111-8 ont, aux fins de la figure 19, une borne commune, et leurs secondes bornes sont respectivement reliées à la tension d'alimentation $V_{DD}$ et à la masse GND.

Le circuit d'adressage 130 des lignes de mot qui sélectionne une colonne mémoire entre le mot 1 et le mot m est configuré et fonctionne comme précédemment.

[Fig. 20] Le circuit de pilotage en courant comprend comme précédemment un circuit de polarisation 120 qui comprend une alimentation de tension polarisant les lignes de bits de 1 à n à des tensions appropriées.

Les sources de tension 121-0 et 121-1 sont, dans ce mode de réalisation, les sources de tension de l'alimentation en tension 121 du circuit de polarisation 120. Elles fournissent les potentiels $V_{BLB}$ et $V_{BL}$ définis vis-à-vis de la masse GND, pour les terminaux BLB et BL, respectivement. Cela est représenté en figure 20.

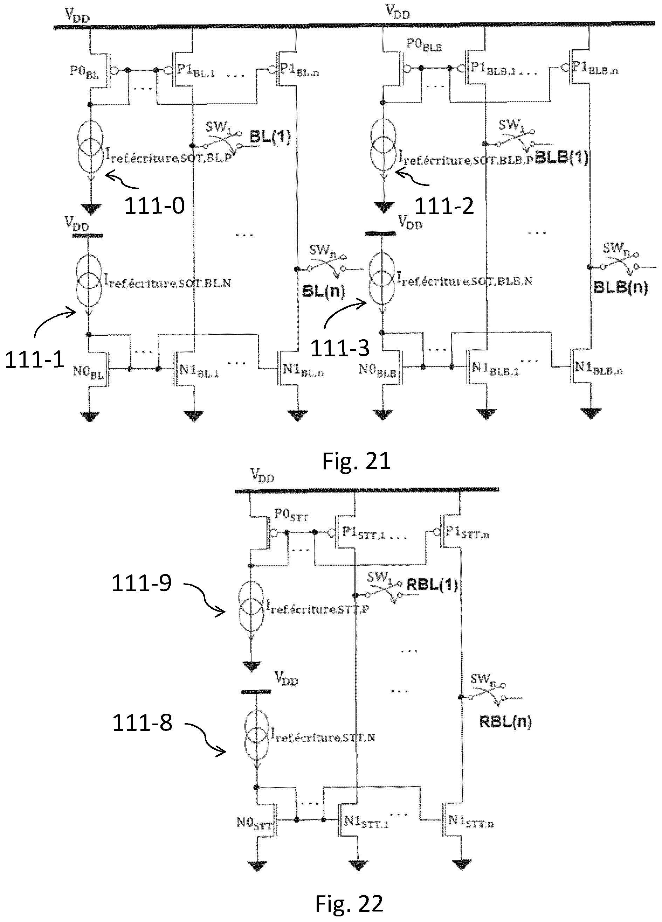

[Fig.21] Le circuit de pilotage en courant peut être réalisé de la manière suivante. Il y a mise en place, et cela est représenté en figure 21,

- de miroirs de courant PMOS fondés sur un unique transistor PMOS $P0_{BL}$ et n transistors $P1_{BL,1}$ à $P1_{BL,n}$ tous en miroirs avec $P0_{BL}$ pour injecter du courant dans les lignes BL
- et de miroirs de courant NMOS fondés sur un unique transistor NMOS $N0_{BL}$ et n transistors $N1_{BL,1}$ à $N1_{BL,n}$ tous en miroirs avec $N0_{BL}$ pour tirer du courant des lignes BL.

Pour tout i entre 1 et n les bornes libres des transistors $P1_{BL,i}$ et $N1_{BL,i}$ (les branches de recopie) sont reliées entre elles et reliées, par le commutateur $SW_i$, au terminal BL(i) de la cellule d'indice i.

Comme précédemment, la source de courant 111-0 est placée entre le potentiel d'alimentation $V_{DD}$ et le potentiel de masse (GND), le transistor PMOS $P0_{BL}$ étant intercalé par sa source et son drain entre l'alimentation $V_{DD}$ et la source de courant 111-0.

Et la source de courant 111-1 est placée entre le potentiel d'alimentation $V_{DD}$ et le potentiel de masse (GND), le transistor NMOS $N0_{BL}$ étant intercalé par son drain et sa source entre la source de courant 111-1 et la masse.

Il y a aussi mise en place

de miroirs de courant PMOS fondés sur un unique transistor PMOS $P0_{BLB}$ et n transistors $P1_{BLB,1}$ à $P1_{BLB,n}$ tous en miroirs avec $P0_{BLB}$ pour injecter du courant dans les lignes BLB,

et de miroirs de courant NMOS fondés sur un unique transistor NMOS $N0_{BLB}$ et n transistors $N1_{BLB,1}$ à $N1_{BLB,n}$ tous en miroirs avec $N0_{BLB}$ pour tirer du courant des lignes BLB.

Pour tout i entre 1 et n les bornes libres des transistors $P1_{BLB,i}$ et $N1_{BLB,i}$ (les branches de recopie) sont reliées entre elles et reliées, par le commutateur $SW_i$ au terminal BLB(i) de la cellule d'indice i.

La source de courant 111-2 est placée entre le potentiel d'alimentation $V_{DD}$ et le potentiel de masse (GND), le transistor PMOS $P0_{BLB}$ étant intercalé par sa source et son drain entre l'alimentation $V_{DD}$ et la source de courant 111-2.

La source de courant 111-3 est placée entre le potentiel d'alimentation $V_{DD}$ et le potentiel de masse (GND), le transistor NMOS $N0_{BLB}$ étant intercalé par son drain et sa source entre la source de courant 111-1 et la masse.

Les miroirs de courant PMOS et NMOS mentionnés ci-dessus servent à l'écriture SOT.

[Fig. 22] Il y a aussi mise en place, et cela est représenté en figure 22 qui prolonge la figure 21,

Pour tout i entre 1 et n les bornes libres des transistors $P1_{STT,i}$ et $N1_{STT,i}$ (les branches de recopie) sont reliées entre elles et reliées, par le commutateur $SW_i$ au terminal RBL(i) de la cellule d'indice i.

La source de courant 111-9 est placée entre le potentiel d'alimentation $V_{DD}$ et le potentiel de masse (GND), le transistor PMOS $P0_{STT}$ étant intercalé par sa source et son drain entre l'alimentation $V_{DD}$ et la source de courant 111-9.

La source de courant 111-8 est placée entre le potentiel d'alimentation $V_{DD}$ et le potentiel de masse (GND), le transistor NMOS $N0_{STT}$ étant intercalé par son drain et sa source entre la source de courant 111-8 et la masse.

L'injection ou le tirage de courant dans les lignes RBL, par les miroirs PMOS et NMOS de la figure 22, sert à l'assistance STT à l'écriture.

L'injection par les miroirs PMOS de la figure 22 sert aussi, en fonction du besoin, à la lecture. Alternativement, il est également possible d'utiliser les miroirs NMOS.

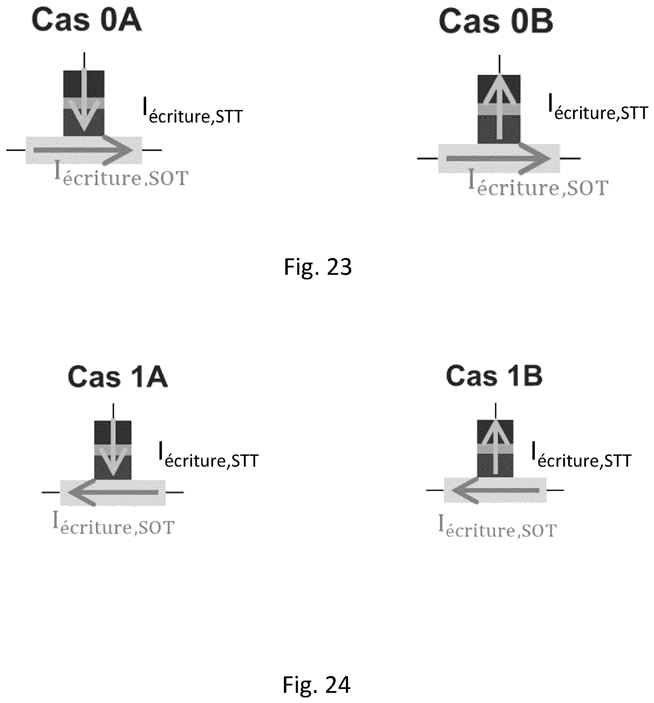

[Fig. 23] Pour sélectionner la colonne mémoire d'indice k, on applique le potentiel $V_{DD}$ à $V_{WL,k}$. Pour la désélectionner, on y applique un potentiel nul.

Pour désélectionner une ligne mémoire d'indice i on bascule le commutateur $SW_i$ à OFF (ouvert). Pour à l'inverse sélectionner une ligne mémoire d'indice i on bascule le commutateur $SW_i$ à ON (fermé).

Une fois une cellule sélectionnée, il existe 4 cas de fonctionnement en écriture, correspondant au fait que les données pouvant devoir être écrites sont au nombre de deux (« 0 » et « 1 ») et que pendant une écriture donnée, le courant d'écriture STT peut circuler à travers le pilier MTJ du haut vers le bas ou du bas vers le haut.

La figure 23 montre donc deux cas, pour l'écriture d'une première donnée, ici notée « 0 ».

| | Écriture '0' | | Écriture '1' | |
|---|---|---|---|---|
| | Cas 0A | Cas 0B | Cas 1A | Cas 1B |
| $SW_i$ | ON | | | |
| $I_{ref,écriture,SOT,BL,P}$ | $I_{ref,écriture,SOT}$ >0 A | 0 A | 0 A | 0 A |
| $I_{ref,écriture,SOT,BL,N}$ | 0 A | 0 A | 0 A | $I_{ref,écriture,SOT}$ >0 A |
| $I_{ref,écriture,SOT,BLB,P}$ | 0 A | 0 A | $I_{ref,écriture,SOT}$ > 0 A | 0 A |
| $I_{ref,écriture,SOT,BLB,N}$ | 0 A | $I_{ref,écriture,SOT}$ >0 A | 0 A | 0 A |
| $I_{ref,écriture,STT,P}$ | $I_{ref,écriture,STT}$ >0 A | 0 A | $I_{ref,écriture,STT}$ > 0 A | 0 A |
| $I_{ref,écriture,STT,N}$ | 0 A | $I_{ref,écriture,STT}$ >0 A | 0 A | $I_{ref,écriture,STT}$ >0 A |
| $SW_{BL}$ | OFF | ON | ON | OFF |
| $V_{BL}$ | - | $V_{DD}$ | 0 V | - |
| $SW_{BLB}$ | ON | OFF | OFF | ON |
| $V_{BLB}$ | 0 V | - | - | $V_{DD}$ |

A gauche de la figure 23, le cas est noté 0A. La source de courant 111-0 est activée avec un courant positif non nul $I_{ref,écriture,SOT,BL,P}$>0A, et les sources de courant 111-1, 111-2, et 111-3 sont coupées : $I_{ref,écriture,SOT,BL,N}$ = $I_{ref,écritu-}$

$_{re,SOT,BLB,P}$ = $I_{ref,écriture,SOT,BLB,N}$ = 0A. Pour couper les sources de courant, alternativement on peut utiliser un interrupteur qui connecte ou déconnecte la connexion entre les sources de courant et les grilles des transistors associés, auquel cas, les grilles sont connectées à GND pour des NMOS, ou $V_{DD}$ pour des PMOS.

La source de courant 111-9 est activée avec un courant positif non nul $I_{ref,écriture,STT,P}$>0A, et la source de courant 111-8 est coupée : $I_{ref,écriture,STT,N}$ = 0A.

Le commutateur $SW_{BL}$ est basculé à OFF (ouvert), le commutateur $SW_{BLB}$ à ON (fermé), et le potentiel $V_{BLB}$ est relié à la masse (0V).

A droite de la figure 23, le cas est noté 0B. La source de courant 111-3 est activée avec un courant positif non nul $I_{ref,écriture,SOT,BLB,N}$>0A, et les sources de courant 111-0, 111-1, et 111-2 sont coupées : $I_{ref,écriture,SOT,BL,P}$ = $I_{ref,écriture,SOT,BL,N}$ = $I_{ref,écriture,SOT,BLB,P}$ = 0A.

La source de courant 111-8 est activée avec un courant positif non nul $I_{ref,écriture,STT,N}$>0A, et la source de courant 111-9 est coupée : $I_{ref,écriture,STT,P}$ = 0A.

Le commutateur $SW_{BL}$ est basculé à ON (fermé), le commutateur $SW_{BLB}$ à OFF (ouvert), et le potentiel $V_{BL}$ est relié à la tension d'alimentation ($V_{DD}$).

[Fig. 24] La figure 24 montre les deux autres cas, pour l'écriture de la deuxième donnée, ici notée « 1 ».

A gauche de la figure 24, le cas est noté 1A. La source de courant 111-2 est activée avec un courant positif non nul $I_{ref,écriture,SOT,BLB,P}$>0A, et les sources de courant 111-0, 111-1, et 111-3 sont coupées : $I_{ref,écriture,SOT,BL,P}$ = $I_{ref,écriture,SOT,BL,N}$ = $I_{ref,écriture,SOT,BLB,N}$ = 0A.

La source de courant 111-9 est activée avec un courant positif non nul $I_{ref,écriture,STT,P}$>0A, et la source de courant 111-8 est coupée : $I_{ref,écriture,STT,N}$ = 0A.

Le commutateur $SW_{BL}$ est basculé à ON (fermé), le commutateur $SW_{BLB}$ à OFF (ouvert), et le potentiel $V_{BL}$ est relié à la masse (0V).

A droite de la figure 24, le cas est noté 1B. La source de courant 111-1 est activée avec un courant positif non nul $I_{ref,écriture,SOT,BL,N}$>0A, et les sources de courant 111-0, 111-2, et 111-3 sont coupées : $I_{ref,écriture,SOT,BL,P}$ = $I_{ref,écriture,SOT,BLB,P}$ = $I_{ref,écriture,SOT,BLB,N}$ = 0A.

La source de courant 111-8 est activée avec un courant positif non nul $I_{ref,écriture,STT,N}$>0A, et la source de courant 111-9 est coupée : $I_{ref,écriture,STT,P}$ = 0A.

Le commutateur $SW_{BL}$ est basculé à OFF (ouvert), le commutateur $SW_{BLB}$ à ON (fermé), et le potentiel $V_{BLB}$ est relié à la tension d'alimentation ($V_{DD}$).

Le fonctionnement en lecture est quant à lui le suivant :

|  | **Lecture** |
|---|---|
| $SW_i$ | ON |
| $I_{ref,écriture,SOT,BL,P}$ | 0 A |
| $I_{ref,écriture,SOT,BL,N}$ | 0 A |
| $I_{ref,écriture,SOT,BLB,P}$ | 0 A |
| $I_{ref,écriture,SOT,BLB,N}$ | 0 A |
| $I_{ref,écriture,STT,P}$ | $I_{ref,lecture}$>0 A |
| $I_{ref,écriture,STT,N}$ | 0 A |
| $SW_{BL}$ | OFF |
| $V_{BL}$ | - |
| $SW_{BLB}$ | ON |
| $V_{BLB}$ | 0 V |

Les sources de courant 111-0, 111-1, 111-2, et 111-3 sont coupées : $I_{ref,écriture,SOT,BL,P}$= $I_{ref,écriture,SOT,BL,N}$ = $I_{ref,écriture,SOT,BLB,P}$ = $I_{ref,écriture,SOT,BLB,N}$ = 0A.

L'une des sources de courant 111-9 (dans la variante du tableau) ou alternativement 111-8 est activée avec un courant positif non nul $I_{ref,lecture}$>0A, et la deuxième de ces deux sources est coupée (0A).

Dans la variante du tableau, le commutateur $SW_{BL}$ est basculé à OFF (ouvert), le commutateur $SW_{BLB}$ à ON (fermé), et le potentiel $V_{BLB}$ est relié à la masse (0V). Alternativement, $V_{BLB}$ est à $V_{DD}$ si la source 111-8 est utilisée pour la lecture.

La méthode est avantageuse, puisque les amplitudes des courants d'écriture SOT et STT sont constantes et contrôlées quelle que soit la position, entre les terminaux de ligne, de la cellule mémoire sélectionnée. Il n'y a pas de dégradation du pilier MTJ (la tension aux bornes du pilier reste limitée).

$I_{\text{écriture,STT}}$ peut être d'environ 20 μA et $I_{\text{écriture,SOT}}$ d'environ 60 à 200 μA, ou plus bas, ou plus haut. En réduisant la valeur de $I_{\text{écriture,SOT}}$, le circuit est plus performant (ie. il est plus simple de dimensionner le circuit et/ou d'utiliser des valeurs plus élevées de $I_{\text{écriture,STT}}$).

Alternativement, on utilise $I_{\text{ref,écriture,STT,N}} = I_{\text{ref,lecture}}$ (et $I_{\text{ref,écriture,STT,P}} = 0A$), auquel cas, $V_{\text{BLB}}$ est portée à $V_{\text{DD}}$.

L'invention s'applique à des structures mono-pilier « single pillar », mais le principe reste le même pour des structures multi-piliers.

L'implémentation proposée permet de couvrir tous les cas possibles. Si on connaît à l'avance les chemins de circulation de $I_{\text{écriture,SOT}}$ et $I_{\text{écriture,STT}}$ dans le circuit, il est possible de simplifier le circuit en supprimant les sources de courant non nécessaires. Ainsi, si on n'utilise le circuit que pour faire de l'assistance en écriture, on peut supprimer 2 des 6 sources de courant du circuit.

Les modes de réalisation présentés utilisent des miroirs de courant pour implémenter les sources de courant, mais il est possible d'utiliser d'autres implémentations pour les sources de courant.

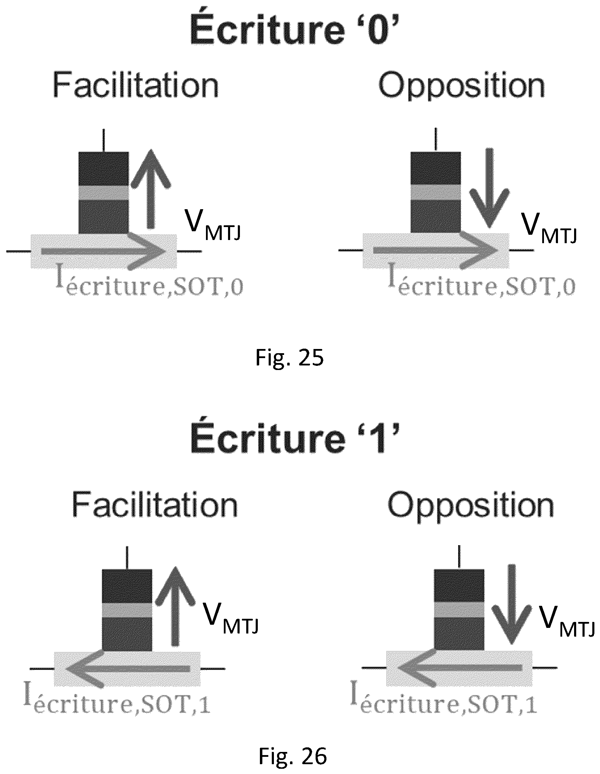

[Fig. 25] En implémentant deux sources de courant par ligne d'accès (BL, BLB, et RBL), il est possible d'assister les opérations d'écriture avec une tension VCMA (pour des piliers MTJ à forte valeur de produit résistance-aire RA, ie. fortes valeurs de résistance).

Dans un mode de réalisation, on effectue l'écriture avec assistance VCMA (voltage-controlled magnetic anisotropy), une technique abordée par exemple dans Y. Wu et al., « Voltage-Gate-Assisted Spin-Orbit-Torque Magnetic Random-Access Memory for High-Density and Low-Power Embedded Applications », Physical Review Applied, 15(6):064015, 2021, ou aussi dans US2016/0232959A1. En plus du courant d'écriture classique circulant à travers la ligne SOT, $I_{\text{écriture,SOT,0}}$ ou $I_{\text{écriture,SOT,1}}$, une tension est également appliquée aux bornes du pilier MTJ, $V_{\text{MTJ}}$, pendant une opération d'écriture '0' ou '1', respectivement. L'écriture avec assistance VCMA est unipolaire : la tension VCMA, $V_{\text{MTJ}}$, permet d'abaisser la barrière potentielle d'énergie entre les états magnétiques parallèle (P) et anti-parallèle (AP) pour faciliter l'écriture.

Le sens de polarisation de la tension $V_{\text{MTJ}}$ ne dépend pas de la donnée à écrire : $V_{\text{MTJ}}$ facilite l'écriture '0' lorsqu'elle est, par exemple, positive entre le haut et le bas du pilier MTJ, comme c'est le cas dans la partie gauche de la figure 25. Il est alors aussi possible, comme c'est le cas dans la partie droite de la figure 25, d'utiliser la tension VCMA pour s'opposer à l'écriture de la donnée '0' en appliquant $V_{\text{MTJ}}$ négative (à l'opposé de la tension utilisée dans le cas de facilitation) entre le haut et le bas du pilier MTJ.

[Fig. 26] $V_{\text{MTJ}}$ facilite aussi l'écriture '1' lorsqu'elle est positive entre le haut et le bas du pilier MTJ, comme c'est le cas dans la partie gauche de la figure 26, et comme c'était le cas pour faciliter l'écriture de la donnée '0' en figure 25. Il est aussi possible d'utiliser la tension VCMA pour s'opposer à l'écriture de la donnée '1' en appliquant $V_{\text{MTJ}}$ négative (à l'opposé de la tension utilisée dans le cas de facilitation) entre le haut et le bas du pilier MTJ, comme c'est le cas dans la partie droite de la figure 26.

Il est nécessaire de contrôler le sens de polarisation de la tension VCMA, $V_{\text{MTJ}}$, indépendamment du sens de circulation du courant d'écriture SOT. L'écriture par assistance VCMA nécessite des produits résistance-aire RA du pilier MTJ élevés, par exemple supérieurs à $20\,\Omega.\mu m^2$. La tension VCMA, $V_{\text{MTJ}}$, permet de réduire le courant d'écriture par SOT nécessaire, $I_{\text{écriture,SOT,0}}$ ou $I_{\text{écriture,SOT,1}}$, lorsqu'il y a facilitation, ou, à l'inverse, augmenter le courant par SOT nécessaire lorsqu'il y a opposition, pour faire par exemple de la sélectivité dans une structure multi-piliers.

Les circuits mémoires SOT-MRAM utilisant l'écriture avec assistance d'une tension VCMA sont parfois pilotés avec des sources de tension constante pour générer le courant d'écriture SOT, $I_{\text{écriture,SOT}}$, et la tension VCMA, $V_{\text{MTJ}}$ :

On retrouve les problèmes montrés précédemment : le courant d'écriture SOT, ainsi que la tension VCMA, ne sont pas uniformes au sein de la matrice mémoire. Il y a diminution du courant SOT et de l'amplitude de la tension VCMA à mesure que l'on s'éloigne des circuits de pilotage, et asymétrie entre l'écriture '0' et '1'. Il est de plus difficile de contrôler précisément et indépendamment le sens de circulation du courant d'écriture SOT et le sens de polarisation de la tension VCMA. Pour faciliter ou s'opposer à l'écriture indépendamment de la donnée à écrire ('0' ou '1'), $V_{\text{MTJ}}$ doit pouvoir être appliquée aux bornes du pilier MTJ dans les deux sens (positive du haut vers le bas, ou positive du bas vers le haut) indépendamment du sens de circulation de $I_{\text{écriture,SOT}}$ - dans la ligne SOT, de BL vers BLB ou de BLB vers BL.

L'amplitude de la tension VCMA (en plus de celle du courant SOT) n'est pas uniforme : elle dépend de la position de la cellule mémoire sélectionnée (de 1 à n) et de la donnée à écrire. Il est de plus difficile de contrôler l'orientation de la tension VCMA.

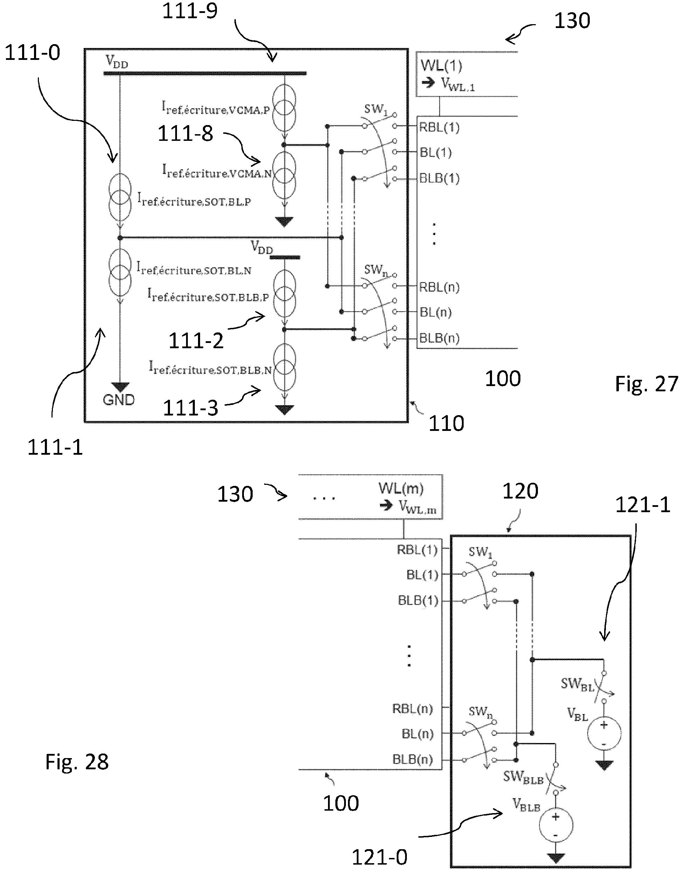

[Fig. 27] Au lieu de piloter la matrice mémoire en tension, on pilote à nouveau la matrice mémoire entièrement en courant. Le circuit de pilotage génère un courant d'écriture SOT de référence, $I_{\text{ref,écriture,SOT}}$, qui circule à travers la ligne SOT de la cellule mémoire sélectionnée. Le circuit de pilotage génère un courant d'écriture VCMA de référence, $I_{\text{ref,écriture,VCMA}}$, qui polarise le pilier MTJ de la cellule mémoire sélectionnée à la tension VCMA souhaitée, $V_{\text{MTJ}}$. Le courant d'écriture SOT et la tension VCMA sont contrôlés indépendamment l'un de l'autre. Le circuit de pilotage utilisé pour générer la tension VCMA permet également d'effectuer les opérations de lecture. Les courants utilisés pour générer la tension VCMA (entre 1 et 5 $\mu$A) sont, généralement, sensiblement les mêmes que les courants utilisés pour la lecture (entre 1 et 10 $\mu$A, selon la valeur de RA du pilier). De plus, le courant utilisé pour générer la tension VCMA ne permet pas seul d'écrire une donnée dans le pilier MTJ. Il est alors possible d'utiliser la même source de courant pour effectuer l'assistance VCMA et la lecture (au choix, soit la source de courant 111-8 soit la source de courant 111-9). Si le courant pour la tension VCMA et le courant pour la lecture sont significativement différents, on ajoute une autre source de courant sur la ligne RBL qui est utilisée seulement pour la lecture.

La proposition de solution résout les problèmes mentionnés précédemment : le courant d'écriture SOT et la tension VCMA de la cellule mémoire sélectionnée, $I_{\text{écriture,SOT}}$ et $V_{MTJ}$, respectivement, sont constants quelle que soit la position de la cellule mémoire sélectionnée et la donnée à écrire ('0' ou '1') ($I_{\text{écriture,SOT}} \approx I_{\text{ref,écriture,SOT}}$ et $V_{MTJ}$ dépend directement de $I_{\text{ref,écriture,VCMA}}$), ie. ce courant et cette tension ne sont pas dépendants de la position et de la donnée à écrire, mais dépendent seulement de $I_{\text{ref,écriture,SOT}}$ et de $I_{\text{ref,écriture,VCMA}}$, respectivement.

Le sens de circulation de $I_{\text{écriture,SOT}}$ et l'orientation de $V_{MTJ}$ sont bidirectionnels et indépendants l'un de l'autre.

Le circuit de pilotage en courant comprend une source de courant qui génère $I_{\text{ref,écriture,SOT}}$, $I_{\text{ref,écriture,VCMA}}$, et $I_{\text{ref,lecture}}$. $I_{\text{ref,lecture}}$ a de préférence la même source que $I_{\text{ref,écriture,VCMA}}$.

Le système comprend comme précédemment un dispositif d'adressage qui connecte les sources de courant aux lignes mémoire sélectionnées (ie. RBL, BL, et BLB sélectionnées).

Les lignes de bits sont polarisées par un circuit dédié. Il y a de plus un circuit d'adressage des lignes de mot qui sélectionne une colonne mémoire, comme précédemment.

La figure 27 montre les sources de courant 111-0, 111-1, 111-2, 111-3, 111-8 et 111-9 positionnées comme leurs homologues de la figure 19. Les source 111-0 et 111-1 génèrent des courants $I_{\text{ref,écriture,SOT,BL,P}}$ et $I_{\text{ref,écriture,SOT,BL,N}}$. Les sources 111-2 et 111-3 génèrent des courant $I_{\text{ref,écriture,SOT,BLB,P}}$ et $I_{\text{ref,écriture,SOT,BLB,N}}$. Les sources 111-9 et 111-8 génèrent des courants $I_{\text{ref,écriture,VCMA,P}}$ et $I_{\text{ref,écriture,VCMA,N}}$.

[Fig. 28] La figure 28 montre la polarisation des lignes de bits du circuit, qui est similaire à celle mise en place dans le mode de réalisation des figures 19 et 20.

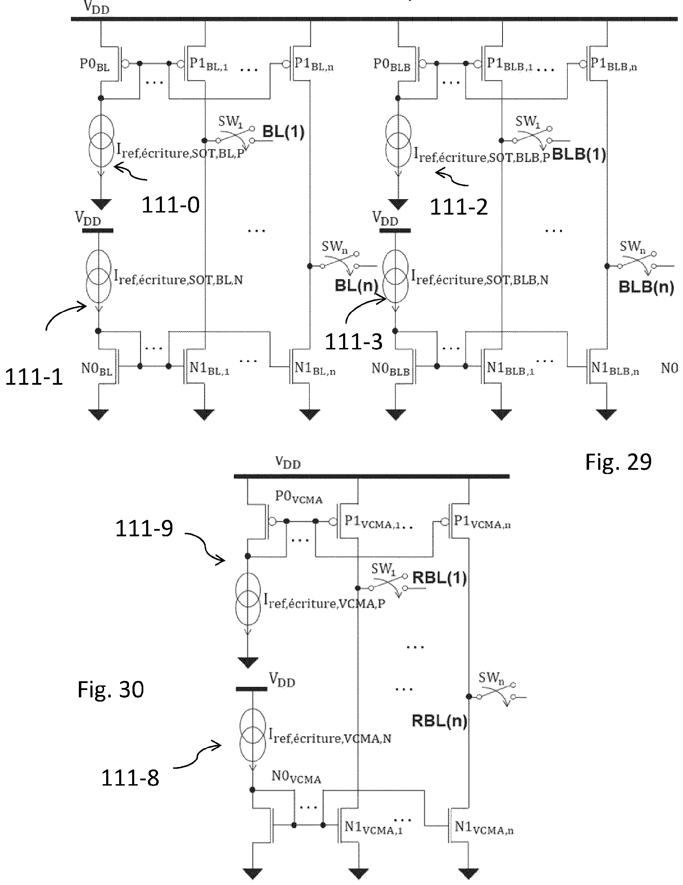

[Fig. 29] La figure 29 montre un exemple d'implémentation des principes de la figure précédente avec des miroirs de courant PMOS et NMOS.

[Fig. 30] La figure 30, qui prolonge la figure 29, montre le fonctionnement des sources de courant 111-8 et 111-9.

Les sources de courant 111-0, 111-1, 111-2 et 111-3 fonctionnent de la même manière que les sources de courant présentées en figure 21.

Il y a ainsi mise en place,

de miroirs de courant PMOS fondés sur un unique transistor PMOS $P0_{VCMA}$ et n transistors $P1_{VCMA,1}$ à $P1_{VCMA,n}$ tous en miroirs avec $P0_{VCMA}$ pour injecter du courant dans les lignes RBL,
et de miroirs de courant NMOS fondés sur un unique transistor NMOS $N0_{VCMA}$ et n transistors $N1_{VCMA,1}$ à $N1_{VCMA,n}$ tous en miroirs avec $N0_{VCMA}$ pour tirer du courant des lignes RBL.

Pour tout i entre 1 et n les bornes libres des transistors $P1_{VCMA,i}$ et $N1_{VCMA,i}$ (les branches de recopie) sont reliées entre elles et reliées, par le commutateur $SW_i$, aux terminaux RBL(i) des cellules de la ligne d'indice i.

L'injection ou le tirage de courant dans les lignes RBL, par les miroirs PMOS et NMOS de la figure 30, sert à l'assistance VCMA à l'écriture.

L'injection par les miroirs PMOS de la figure 30 sert aussi, en fonction du besoin, à la lecture. Alternativement, on peut également utiliser les miroirs de courant NMOS.

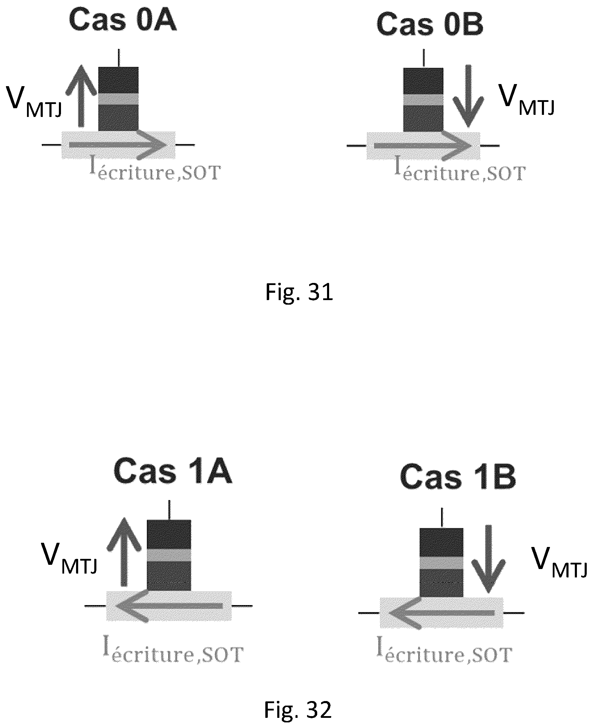

[Fig. 31] Pour sélectionner la colonne mémoire d'indice k, on applique le potentiel $V_{DD}$ à $V_{WL,k}$. Pour la désélectionner, on y applique un potentiel nul.

Pour désélectionner une ligne mémoire d'indice i on bascule le commutateur $SW_i$ à OFF (ouvert). Pour à l'inverse sélectionner une ligne mémoire d'indice i on bascule le commutateur $SW_i$ à ON (fermé).

Une fois une cellule sélectionnée, il existe 4 cas de fonctionnement en écriture, correspondant au fait que deux données différentes peuvent devoir être écrites (« 0 » et « 1 ») et que pendant une écriture donnée, la tension VCMA aux extrémités du pilier MTJ peut être orientée dans un sens ou dans l'autre.

La figure 31 montre donc deux cas, pour l'écriture d'une première donnée, ici notée « 0 ».

| | Écriture '0' | | Écriture '1' | |
|---|---|---|---|---|
| | Cas 0A | Cas 0B | Cas 1A | Cas 1B |
| $SW_i$ | ON | | | |
| $I_{\text{ref,écriture,SOT,BL,P}}$ | $I_{\text{ref,écriture,SOT}} > 0$ A | 0 A | 0 A | 0 A |

(suite)

| | Écriture '0' | | | Écriture '1' | |
|---|---|---|---|---|---|
| | Cas 0A | | Cas 0B | Cas 1A | Cas 1B |
| $I_{ref,écriture,SOT,BL,N}$ | 0 A | 0 A | 0 A | $I_{ref,écriture,SOT} > 0\ A$ | |
| $I_{ref,écriture,SOT,BLB,P}$ | 0 A | 0 A | $I_{ref,écriture,SOT} > 0\ A$ | 0 A | |
| $I_{ref,écriture,SOT,BLB,N}$ | 0 A | $I_{ref,écriture,SOT} > 0\ A$ | 0 A | 0 A | |
| $I_{ref,écriture,VCMA,P}$ | $I_{ref,écriture,VCMA} > 0\ A$ | 0 A | $I_{ref,écriture,VCMA} > 0\ A$ | 0 A | |
| $I_{ref,écriture,VCMA,N}$ | 0 A | $I_{ref,écriture,VCMA} > 0\ A$ | 0 A | $I_{ref,écriture,VCMA} > 0\ A$ | |
| $SW_{BL}$ | OFF | ON | ON | OFF | |
| $V_{BL}$ | - | $V_{DD}$ | 0 V | - | |
| $SW_{BLB}$ | ON | OFF | OFF | ON | |
| $V_{BLB}$ | 0 V | - | - | $V_{DD}$ | |

A gauche de la figure 31, le cas est noté 0A. La source de courant 111-0 est activée avec un courant positif non nul $I_{ref,écriture,SOT,BL,P} > 0A$, et les sources de courant 111-1, 111-2, et 111-3 sont coupées : $I_{ref,écriture,SOT,BL,N} = I_{ref,écriture,SOT,BLB,P} = I_{ref,écriture,SOT,BLB,N} = 0A$.

La source de courant 111-9 est activée avec un courant positif non nul $I_{ref,écriture,VCMA,P} > 0A$, et la source de courant 111-8 est coupée : $I_{ref,écriture,VCMA,N} = 0A$.

Le commutateur $SW_{BL}$ est basculé à OFF (ouvert), le commutateur $SW_{BLB}$ à ON (fermé), et le potentiel $V_{BLB}$ est relié à la masse (0V).

A droite de la figure 31, le cas est noté 0B. La source de courant 111-3 est activée avec un courant positif non nul $I_{ref,écriture,SOT,BLB,N} > 0A$, et les sources de courant 111-0, 111-1, et 111-2 sont coupées : $I_{ref,écriture,SOT,BL,P} = I_{ref,écriture,SOT,BL,N} = I_{ref,écriture,SOT,BLB,P} = 0A$.

La source de courant 111-8 est activée avec un courant positif non nul $I_{ref,écriture,VCMA,N} > 0A$, et la source de courant 111-9 est coupée : $I_{ref,écriture,VCMA,P} = 0A$.

Le commutateur $SW_{BL}$ est basculé à ON (fermé), le commutateur $SW_{BLB}$ à OFF (ouvert), et le potentiel $V_{BL}$ est relié à la tension d'alimentation ($V_{DD}$).

[Fig. 32] La figure 32 montre les deux autres cas, pour l'écriture de la deuxième donnée, ici notée « 1 ».

A gauche de la figure 32, le cas est noté 1A. La source de courant 111-2 est activée avec un courant positif non nul $I_{ref,écriture,SOT,BLB,P} > 0A$, et les sources de courant 111-0, 111-1, et 111-3 sont coupées : $I_{ref,écriture,SOT,BL,P} = I_{ref,écriture,SOT,BL,N} = I_{ref,écriture,SOT,BLB,N} = 0A$.

La source de courant 111-9 est activée avec un courant positif non nul $I_{ref,écriture,VCMA,P} > 0A$, et la source de courant 111-8 est coupée : $I_{ref,écriture,VCMA,N} = 0A$.

Le commutateur $SW_{BL}$ est basculé à ON (fermé), le commutateur $SW_{BLB}$ à OFF (ouvert), et le potentiel $V_{BL}$ est celui de la masse (0V).

A droite de la figure 32, le cas est noté 1B. La source de courant 111-1 est activée avec un courant positif non nul $I_{ref,écriture,SOT,BL,N} > 0A$, et les sources de courant 111-0, 111-2, et 111-3 sont coupées : $I_{ref,écriture,SOT,BL,P} = I_{ref,écriture,SOT,BLB,P} = I_{ref,écriture,SOT,BLB,N} = 0A$.

La source de courant 111-8 est activée avec un courant positif non nul $I_{ref,écriture,VCMA,N} > 0A$, et la source de courant 111-9 est coupée : $I_{ref,écriture,VCMA,P} = 0A$.

Le commutateur $SW_{BL}$ est basculé à OFF (ouvert), le commutateur $SW_{BLB}$ à ON (fermé), et le potentiel $V_{BLB}$ est celui de la tension d'alimentation ($V_{DD}$).

Le fonctionnement en lecture est quant à lui le suivant (il est identique à celui mentionné en lien avec les figures 23 et 24) :

| | **Lecture** |
|---|---|
| $SW_i$ | ON |
| $I_{ref,écriture,SOT,BL,P}$ | 0 A |

(suite)

|  | Lecture |
| --- | --- |
| $I_{ref,écriture,SOT,BL,N}$ | 0 A |
| $I_{ref,écriture,SOT,BLB,P}$ | 0 A |
| $I_{ref,écriture,SOT,BLB,N}$ | 0 A |
| $I_{ref,écriture,VCMA,P}$ | $I_{ref,lecture}>0$ A |
| $I_{ref,écriture,VCMA,N}$ | 0 A |
| $SW_{BL}$ | OFF |
| $V_{BL}$ | - |
| $SW_{BLB}$ | ON |
| $V_{BLB}$ | 0 V |

Les sources de courant 111-0, 111-1, 111-2, et 111-3 sont coupées : $I_{ref,écriture,SOT,BL,P}$ = $I_{ref,écriture,SOT,BL,N}$ = $I_{ref,écriture,SOT,BLB,P}$ = $I_{ref,écriture,SOT,BLB,N}$ = 0A.

L'une des sources de courant 111-9 dans la variante présentée au tableau ou alternativement 111-8 est activée avec un courant positif non nul $I_{ref,lecture}>0$A, et la deuxième de ces deux sources est coupée (0A).

Le commutateur $SW_{BL}$ est basculé à OFF (ouvert), le commutateur $SW_{BLB}$ à ON (fermé), et le potentiel $V_{BLB}$ est relié à la masse (0V).

Les amplitudes du courant d'écriture SOT et de la tension VCMA sont essentiellement constantes de la première à la dernière cellule et contrôlées quelle que soit la position de la cellule mémoire sélectionnée.

Pendant une écriture, la tension VCMA à travers le pilier MTJ peut être orientée du haut vers le bas ou du bas vers le haut.

Il n'y a pas de dégradation du pilier MTJ ($V_{MTJ}<1$ V).

Une tension VCMA, $V_{MTJ}$, d'environ 250 mV pourrait, d'après des simulations, réduire le courant SOT nécessaire, $I_{écriture,SOT}$ de 30%. Il est possible, d'après des simulations, d'avoir $V_{MTJ}$ à 250 mV avec $I_{écriture,SOT}$=200 µA. En réduisant la valeur de $I_{écriture,SOT}$, le circuit est plus simple à dimensionner et à utiliser avec des valeurs plus élevées de $V_{MTJ}$.

Alternativement, on utilise $I_{ref,écriture,VCMA,N}$ = $I_{ref,lecture}$ et $I_{ref,écriture,VCMA,P}$ = 0A, auquel cas, $V_{BLB}$ = $V_{DD}$.

L'invention a été présentée avec des structures piliers uniques « single pillar », mais est appliquée également dans d'autres modes de réalisation à des structures multi-piliers.

De manière générale, on supprime les sources de courant non nécessaires. Si on n'utilise le circuit que pour faire de l'assistance en écriture, on supprime 3 des 6 sources de courant du circuit.

## Revendications

1. Circuit électronique de mémoire vive comprenant une matrice (100) de cellules mémoires (10) incluant chacune au moins un pilier magnétique et une ligne à effet Hall de spin interagissant par couplage spin-orbite et formant un tripôle (BE1, BE2, TE), chaque cellule (10) comprenant de plus un moyen de sélection (N1, N2) de la connexion aux bornes dudit tripôle (BE1, BE2, TE),

   ◦ un terminal (WL(k)) de chaque cellule étant relié dans le circuit pour la sélection de cellules mémoires de la matrice selon une première dimension de la matrice à l'aide des moyens de sélection (N1, N2) des cellules mémoires,
   ◦ et une paire de terminaux (BLB(i), RBL(i) ; BL(i), BLB(i)) de chaque cellule étant reliée dans le circuit pour permettre une application commune, à des cellules mémoires de la matrice sélectionnées selon une deuxième dimension de la matrice, d'une énergie électrique pour la lecture ou l'écriture d'une information magnétique dans le pilier,

   ledit circuit électronique de mémoire vive étant **caractérisé en ce que** ladite énergie électrique est appliquée en faisant circuler un courant contrôlé par un circuit de pilotage de la matrice mémoire en courant (111) au moins un générateur de courant du circuit de pilotage faisant circuler un courant constant dans des lignes de bits de la matrice, et un circuit de polarisation comprenant une alimentation en tension qui polarise lesdites lignes de bits à des tensions appropriées pour le pilotage en courant.

2.  Circuit électronique de mémoire vive selon la revendication 1, **caractérisé en ce que** l'énergie électrique est appliquée par des branches de recopie de miroirs de courant ($P1_{E0,1}$, $P1_{E0}$ ; $N1_{E1,1}$, $N1_{E1,n}$ ; $P1_{L,1}$, $P1_{L,n}$) chacune associée à une ligne de cellules selon la deuxième dimension, un transistor desdits miroirs de courant étant mutualisé pour former une branche de référence commune desdits miroirs de courant.

3.  Circuit électronique de mémoire vive selon la revendication 1 ou la revendication 2, **caractérisé en ce que** l'énergie électrique est appliquée par une branche de recopie ($P1_{E0}$ ; $N1_{E1}$ ; $P1_L$) commune à plusieurs lignes de cellules selon la deuxième dimension de la matrice, un contrôleur (115) du circuit sélectionnant une ligne de cellules pour la connecter sélectivement à ladite branche de recopie commune.

4.  Circuit électronique de mémoire vive selon l'une des revendications 1 à 3, **caractérisé en ce que** l'énergie électrique pour l'écriture est appliquée en connectant à une même borne de la ligne à effet Hall de spin une première source de courant avec miroir de courant associé PMOS ($P1_{E0,1}$, $P1_{E0,n}$ ; $P1_{E0}$) pour l'écriture de la première valeur binaire, et une deuxième source de courant avec miroir de courant associé NMOS ($N1_{E1,1}$, $N1_{E1,n}$ ; $N1_{E1}$) pour l'écriture de la deuxième valeur binaire.

5.  Circuit électronique de mémoire vive selon l'une des revendications 1 à 4, **caractérisé en ce que** l'énergie électrique pour l'écriture est appliquée en connectant une source de courant (111-0, 111-1) à une première borne (BL, BLB) de la ligne à effet Hall de spin pour l'écriture de la première valeur binaire et à une deuxième borne (BL, BLB) de la ligne à effet Hall de spin pour l'écriture de la deuxième valeur binaire, un contrôleur (116) du circuit polarisant la borne (BL, BLB) de la ligne à effet Hall opposée à la source de courant en fonction de la valeur binaire à écrire.

6.  Circuit électronique de mémoire vive selon l'une des revendications 1 à 5, **caractérisé en ce que** l'énergie électrique pour la lecture est appliquée en connectant une source de courant (111-9) à une extrémité du pilier magnétique opposée à la ligne à effet Hall de spin, la ligne à effet Hall de spin étant polarisée pour l'opération de lecture.

7.  Circuit électronique de mémoire vive selon l'une des revendications 1 à 6, **caractérisé en ce que** l'énergie électrique pour la lecture est appliquée dans le pilier magnétique dans un premier sens ou un sens opposé en fonction d'une valeur écrite au cours d'une opération d'écriture simultanée.

8.  Circuit électronique de mémoire vive selon l'une des revendications 1 à 7, **caractérisé en ce que** le circuit de pilotage en courant (110) fait de plus circuler un courant d'assistance ($I_{écriture,STT}$ ; $I_{écriture,VCMA}$) à travers le pilier magnétique pour faciliter ou empêcher l'écriture.

9.  Circuit électronique de mémoire vive selon l'une des revendications 1 à 8, **caractérisé en ce que** le circuit électronique de mémoire vive magnétique comprend un circuit de polarisation (120) placé par rapport à la matrice (100) en opposition vis-à-vis du circuit de pilotage en courant (110).

10. Circuit électronique de mémoire vive selon l'une des revendications 1 à 9, **caractérisé en ce que** le moyen de sélection comprend deux transistors à effet de champ (N1, N2) reliés chacun par une source ou un drain à une borne respective de l'ensemble formé par le pilier magnétique et la ligne à effet Hall de spin.

11. Circuit électronique de mémoire vive selon l'une des revendications 1 à 10, **caractérisé en ce que** les cellules sont des cellules SOT-5T, SWL1 ou SWL2.

12. Circuit électronique de mémoire vive selon l'une des revendications 1 à 11, **caractérisé en ce que** les cellules mémoires (10) sont des cellules à pilier magnétique unique, ou à quatre piliers magnétiques, ou à un autre nombre de piliers magnétique inférieur à 20.

Fig. 1

Fig. 2

10

RBL

RWL

N2

TE

MTJ

BLB

Fig. 3

WWL

N1

BL

BE1

LSOT

BE2

WL

RBL

(RWL)

10

(WWL)

BLB

Fig. 4

BL

130

110

WWL(1)
RWL(1)

· · ·

WWL(m)
RWL(m)

120

100

110

111

RBL(1)
BL(1)
BLB(1)

⋮

RBL(n)
BL(n)
BLB(n)

120

121

RBL(1)
BL(1)
BLB(1)

⋮

RBL(n)
BL(n)
BLB(n)

Fig. 5

Fig. 6

Fig. 7A

111         100         121

WL(k)

RBL(i)

10

BLB(i)

Fig. 7B

111         100         121

WL(k)

10

BL(i)

BLB(i)

Fig. 7C

Fig. 8A

Fig. 8B

BL

RWL

BLB

WWL

BL

Fig. 9

RBL

WL

WL

Fig. 10

BL

BLB

$V_{DD}$

$P0_{E0}$  $P1_{E0}$

$P0_L$  $P1_L$

$SW_1$  BL(1)

$I_{ref,écriture,0}$

111-0

$V_{DD}$

$I_{ref,écriture,1}$

111-1

$SW_n$  BL(n)

$N0_{E1}$  $N1_{E1}$

$I_{ref,lecture}$

111-9

$SW_1$  RBL(1)

$SW_n$  RBL(n)

115

Fig. 11

Fig. 12

Fig. 13

Fig. 14

Fig. 15

Fig. 16

Fig. 17

Fig. 18

111-9

130

111-0

$V_{DD}$

$I_{ref,écriture,STT,P}$

111-8

$I_{ref,écriture,STT,N}$

$I_{ref,écriture,SOT,BL,P}$

$I_{ref,écriture,SOT,BL,N}$

$I_{ref,écriture,SOT,BLB,P}$

111-2

$V_{DD}$

$I_{ref,écriture,SOT,BLB,N}$

111-3

GND

111-1

$SW_1$

RBL(1)

BL(1)

BLB(1)

$SW_n$

RBL(n)

BL(n)

BLB(n)

WL(1)
→ $V_{WL,1}$

...

100

110

Fig. 19

130

... 

WL(m)
→ $V_{WL,m}$

120

RBL(1)

BL(1)

BLB(1)

$SW_1$

$SW_{BL}$

$V_{BL}$

121-1

RBL(n)

BL(n)

BLB(n)

$SW_n$

$SW_{BLB}$

$V_{BLB}$

100

121-0

Fig. 20

Fig. 21

Fig. 22

## Cas 0A

$I_{\text{écriture,STT}}$

$I_{\text{écriture,SOT}}$

## Cas 0B

$I_{\text{écriture,STT}}$

$I_{\text{écriture,SOT}}$

Fig. 23

## Cas 1A

$I_{\text{écriture,STT}}$

$I_{\text{écriture,SOT}}$

## Cas 1B

$I_{\text{écriture,STT}}$

$I_{\text{écriture,SOT}}$

Fig. 24

# Écriture '0'

Facilitation                                    Opposition

$V_{MTJ}$                                        $V_{MTJ}$

$I_{écriture,SOT,0}$                             $I_{écriture,SOT,0}$

Fig. 25

# Écriture '1'

Facilitation                                    Opposition

$V_{MTJ}$                                        $V_{MTJ}$

$I_{écriture,SOT,1}$                             $I_{écriture,SOT,1}$

Fig. 26

111-9

111-0

130

$V_{DD}$

$I_{ref,écriture,VCMA,P}$

111-8

$I_{ref,écriture,VCMA,N}$

$I_{ref,écriture,SOT,BL,P}$

$V_{DD}$

$I_{ref,écriture,SOT,BL,N}$

$I_{ref,écriture,SOT,BLB,P}$

111-2

$I_{ref,écriture,SOT,BLB,N}$

GND

111-3

111-1

$SW_1$

$SW_n$

WL(1)
→ $V_{WL,1}$

RBL(1)

BL(1)

BLB(1)

RBL(n)

BL(n)

BLB(n)

100

110

Fig. 27

130

WL(m)
→ $V_{WL,m}$

120

121-1

RBL(1)

BL(1)

BLB(1)

$SW_1$

RBL(n)

BL(n)

BLB(n)

$SW_n$

$SW_{BL}$

$V_{BL}$

$SW_{BLB}$

$V_{BLB}$

Fig. 28

100

121-0

Fig. 29

Fig. 30

**Cas 0A**

**Cas 0B**

$V_{MTJ}$

$V_{MTJ}$

$I_{écriture,SOT}$

$I_{écriture,SOT}$

Fig. 31

**Cas 1A**

**Cas 1B**

$V_{MTJ}$

$V_{MTJ}$

$I_{écriture,SOT}$

$I_{écriture,SOT}$

Fig. 32

**Europäisches Patentamt**
**European Patent Office**
**Office européen des brevets**

## RAPPORT DE RECHERCHE EUROPEENNE

Numéro de la demande

EP 25 19 9744

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2023/280978 A1 (XING GUOZHONG [CN] ET AL) 7 septembre 2023 (2023-09-07) * alinéa [0039] - alinéa [0043]; figure 1 * * alinéa [0047]; figure 4 * | 1-12 | INV. G11C11/16 G11C11/18 |
| Y | US 2022/359615 A1 (LUO ZONG-YOU [TW] ET AL) 10 novembre 2022 (2022-11-10) * alinéa [0024] - alinéa [0039]; figures 1-3 * | 1-12 | |
| A | US 9 824 735 B1 (KAN JIMMY JIANAN [US] ET AL) 21 novembre 2017 (2017-11-21) * le document en entier * | 1-12 | |
| A | GUPTA M ET AL: "Challenges with SOT-MRAM integration towards N5 node and beyond", PROCEEDINGS OF THE SPIE, SPIE, US, vol. 12052, 26 mai 2022 (2022-05-26), pages 1205202-1205202, XP060160184, ISSN: 0277-786X, DOI: 10.1117/12.2613482 ISBN: 978-1-5106-5738-0 * le document en entier * | 1-12 | **DOMAINES TECHNIQUES RECHERCHES (IPC)** G11C |

Le présent rapport a été établi pour toutes les revendications

| Lieu de la recherche | Date d'achèvement de la recherche | Examinateur |
|---|---|---|
| La Haye | 19 janvier 2026 | Lecoutre, Renaud |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

# EP 4 712 078 A1

## ANNEXE AU RAPPORT DE RECHERCHE EUROPEENNE
## RELATIF A LA DEMANDE DE BREVET EUROPEEN NO.

EP 25 19 9744

19-01-2026

| Document brevet cité au rapport de recherche | Date de publication | Membre(s) de la famille de brevet(s) | Date de publication |
|---|---|---|---|
| US 2023280978 A1 | 07-09-2023 | US 2023280978 A1 | 07-09-2023 |
| | | WO 2021253826 A1 | 23-12-2021 |
| US 2022359615 A1 | 10-11-2022 | CN 111129291 A | 08-05-2020 |
| | | TW 202017003 A | 01-05-2020 |
| | | US 2020135804 A1 | 30-04-2020 |
| | | US 2022359615 A1 | 10-11-2022 |
| | | US 2025056812 A1 | 13-02-2025 |
| US 9824735 B1 | 21-11-2017 | AUCUN | |

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20180061467 A1
- EP 3671749 A1
- US 20160232959 A1

**Littérature non-brevet citée dans la description**

- **KRIZAKOVA et al.** Spin-orbit torque switching of magnetic tunnel junctions for memory applications. *Journal of Magnetism and Magnetic Materials*, 2022, vol. 562, 169692
- **S. LEE et al.** Emerging Three-Terminal Magnetic Memory Devices. *Proceedings of the IEEE*, 2016, vol. 104 (10), 1831-1843
- **T. NA et al.** STT-MRAM Sensing: A Review. *IEEE Transactions on Circuits and Systems II: Express Briefs*, 2021, vol. 68 (1), 12-18
- **M. GUPTA et al.** High-density SOT-MRAM technology and design specifications for the embedded domain at 5nm node. *IEEE IEDM*, 2020
- **E. GRIMALDI et al.** Single-shot dynamics of spin-orbit torque and spin transfer torque switching in three-terminal magnetic tunnel junctions. *Nature Nanotechnology*, 2020, vol. 15 (2), 111-117
- **Y. WU et al.** Voltage-Gate-Assisted Spin-Orbit-Torque Magnetic Random-Access Memory for High-Density and Low-Power Embedded Applications. *Physical Review Applied*, 2021, vol. 15 (6), 064015